# EUROPÄISCHE PATENTSCHRIFT

(11) **EP 4 122 633 B1**
(45) Veröffentlichungstag und Bekanntmachung des Hinweises auf die Patenterteilung: **19.03.2025**
(21) Anmeldenummer: 22195120.5
(22) Anmeldetag: 27.11.2015
(51) Int. Cl.: B23K 26/00, B23K 26/402, H01L 21/78, B28D 5/00, B23K 26/40, B23K 26/53, B23K 103/00

(54) **FESTKÖRPERTEILUNG MITTELS STOFFUMWANDLUNG**
SOLID BODY DIVISION BY CONVERSION OF SUBSTANCES
DIVISION DE CORPS SOLIDE AU MOYEN D'UNE CONVERSION DE SUBSTANCES

(30) Priorität: 27.11.2014 DE 102014017583; 27.11.2014 DE 102014017582; 17.12.2014 DE 102014018720; 17.12.2014 DE 102014018841; 15.01.2015 DE 102015000449
(43) Veröffentlichungstag der Anmeldung: 25.01.2023
(62) Teilanmeldung aus: 20151833.9
(73) Patentinhaber: Siltectra GmbH, 01099 Dresden (DE)
(72) Erfinder: RICHTER, Jan, 01277 Dresden (DE); BEYER, Christian, 09599 Freiberg (DE); RIESKE, Ralf, 01099 Dresden (DE)
(74) Vertreter: Müller Hoffmann & Partner

(56) Entgegenhaltungen:
- WO-A1-2014/111385
- WO-A1-2014/177721
- WO-A2-2013/126927

## Beschreibung

Die vorliegende Erfindung bezieht sich gemäß dem Anspruch 1 auf ein Verfahren zum Erzeugen eines Ablösebereichs in einem Festkörper zum Ablösen eines Festkörperanteils von dem Festkörper.

Das Teilen von Festkörpern, insbesondere von Wafern, wird klassisch durch Sägen bewirkt. Dieses Trennverfahren hat jedoch eine Vielzahl an Nachteile. So werden beim Sägen stets Späne erzeugt, die somit zerstörtes Grundmaterial darstellen. Ferner nimmt die Dickenschwankung der abgesägten Scheiben bei einer Zunahme der Sägehöhe ebenfalls zu. Weiterhin bewirkt das Sägeelement, dass auf den Oberflächen der voneinander zu trennenden Scheiben Riefen und Oberflächenschädigungen entstehen.

Es ist daher ersichtlich, dass das Trennverfahren "Sägen" sehr hohe Materialkosten und Kosten für die Nacharbeit bedingt.

Ferner offenbart die Druckschrift WO 2013/126927 A2 ein Verfahren zum Abtrennen von Geräteschichten von einem Ausgangswafer. Gemäß der WO 2013/126927 A2 erfolgt dabei ein sehr starkes Aufheizen der Gesamtanordnung infolge einer Laserbeaufschlagung. Diese Aufheizung wird benötigt um über die unterschiedlichen Wärmeausdehnungskoeffizienten des Festkörpermaterials und einem "Handler" Spannungen im Inneren des Festkörpers zu erzielen. Es ist hierbei ersichtlich, dass die thermische Beanspruchbarkeit des "Handlers" sehr hoch sein muss, da sehr hohe Temperaturen auftreten. Ferner werden gemäß der WO 2013/126927 A2 die Laserstrahlen immer über eine Oberfläche in den Festkörper eingeleitet, die nicht Bestandteil der abzutrennenden Schicht ist. Dies führt ebenfalls zu einer starken Aufheizung des Festkörpers. Die hohen Temperaturen haben ebenfalls den Nachteil, dass sich der Festkörper verzieht oder ungewollt ausdehnt, wodurch die Erzeugung von Kristallgittermodifikationen nur sehr unpräzise möglich ist.

Gemäß der WO 2013/126927 A2 lassen sich somit keine dicken und großen Festkörper bearbeiten. Die WO 2013/115352 A1 offenbart ein Herstellungsverfahren für monokristalline Substrate.

Es ist daher die Aufgabe der vorliegenden Erfindung ein alternatives Verfahren zum Abtrennen von Festkörperanteilen, insbesondere von mehreren Festkörperschichten, von einem Festkörper bereitzustellen. Die zuvor genannte Aufgabe wird erfindungsgemäß durch das Verfahren nach Anspruch 1 gelöst.

Dieses Verfahren umfasst erfindungsgemäß bevorzugt mindestens die Schritte:
Bereitstellen eines zu bearbeitenden Festkörpers, wobei der Festkörper bevorzugt aus einer chemischen Verbindung besteht; Bereitstellen einer LASER-Lichtquelle; Beaufschlagen des Festkörpers mit LASER-Strahlung der LASER-Lichtquelle, wobei die Laserstrahlen über eine Oberfläche des abzutrennenden Festkörperanteils in den Festkörper eindringen, wobei die LASER-Strahlung einen vorgegebenen Anteil des Festkörpers im Inneren des Festkörpers zur Ausbildung eines Ablösebereichs oder mehrerer Teilablösebereiche definiert beaufschlagt. Bevorzugt ist die in dem vorgegebenen Anteil des Festkörpers erzeugte Temperatur so hoch, dass das den vorgegebenen Anteil ausbildende Material Modifikationen in Form einer vorbestimmten Stoffumwandlung erfährt, wobei durch die Modifikationen der Ablösebereich vorgegeben wird oder mehrere Teilablösebereiche vorgegeben werden. Zusätzlich oder alternativ werden durch die Laserbeaufschlagung nacheinander mehrere Modifikationen in dem Kristallgitter erzeugt, wobei das Kristallgitter in Folge der Modifikationen in den die Modifikationen umgebenden Bereichen zumindest in jeweils einem Anteil davon einreist, wobei durch die Risse im Bereich der Modifikationen der Ablösebereich vorgegeben wird oder mehrere Teilablösebereiche vorgegeben werden.

Diese Lösung ist vorteilhaft, da eine Stoffumwandlung bzw. Phasenumwandlung bevorzugt ohne ein lokales Zerstören des Kristallgitters bewirkt werden kann, wodurch sehr kontrolliert eine Schwächung bzw. Festigkeitsreduzierung in dem Festkörper erzeugt werden kann.

Ferner schafft die vorliegende Erfindung erstmals eine Möglichkeit, dass ein Festkörper nicht orthogonal zu seiner zu kürzenden Längsrichtung gekürzt werden muss, sondern dass er mit dem LASER in seiner Längsrichtung derart beaufschlagt wird, dass eine Festkörperschicht abgetrennt wird. Dieses Verfahren hat ferner den Vorteil, dass die LASER-Strahlen nicht über den gesamten Radius des Festkörpers in den Festkörper eindringen müssen, sondern über eine zur Abtrennschicht bzw. Ablöseschicht bevorzugt parallelen Schicht in den Festkörper eingebracht werden können. Dies ist insbesondere bei Festkörpern sinnvoll, deren Radius größer oder gleich der Dicke der abzutrennenden Festkörperschicht ist.

Weitere bevorzugte Ausführungsformen sind Gegenstand der Unteransprüche und der nachfolgenden Beschreibungsteile.

Die Stoffumwandlung stellt gemäß einer weiteren bevorzugten Ausführungsform der vorliegenden Erfindung eine Zerlegung der chemischen Verbindung in mehrere oder in alle einzelne Bestandteile bzw. Elemente dar. Diese Ausführungsform ist vorteilhaft, da durch die gezielte Zerlegung der chemischen Verbindung des Festkörpers die für eine Abtrennung des Festkörperanteils am besten geeignete Materialkombination definiert eingestellt werden kann.

Gemäß der vorliegenden Beschreibung wird unter einem Festkörper-Ausgangsmaterial bevorzugt ein monokristallines, polykristallines oder amorphes Material verstanden. Bevorzugt eignen sich wegen der stark anisotropen atomaren Bindungskräfte Monokristalline mit einer stark anisotropen Struktur. Das Festkörper-Ausgangsmaterial weist bevorzugt ein Material oder eine Materialkombination aus einer der Hauptgruppen 3, 4, 5 und/oder der Nebengruppe 12 des Periodensystems der Elemente, insbesondere eine Kombination aus Elementen der 3.,4., 5. Hauptgruppe und der Nebengruppe 12, wie z.B. Zinkoxid oder Cadmiumtellurid, auf.

Neben Siliziumcarbit kann das Halbleiter-Ausgangsmaterial beispielsweise auch aus Silizium, Galliumarsenid GaAs, Galliumnitrid GaN, Siliciumcarbid SiC, Indiumphosphid InP, Zinkoxid ZnO, Aluminiumnitrid AIN, Germanium, Gallium(III)-oxid Ga2O3, Aluminiumoxid Al2O3 (Saphir), Galliumphosphid GaP, Indiumarsenid InAs, Indiumnitrid InN, Aluminiumarsenid AlAs oder Diamant bestehen.

Der Festkörper bzw. das Werkstück (z.B. Wafer) weist bevorzugt ein Material oder eine Materialkombination aus einer der Hauptgruppen 3, 4 und 5 des Periodensystems der Elemente auf, wie z.B. SiC, Si, SiGe, Ge, GaAs, InP, GaN, Al2O3 (Saphir), AIN. Besonders bevorzugt weist der Festkörper eine Kombination aus der vierten, dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Der Festkörper ist bevorzugt ein Ingot oder ein Wafer. Besonders bevorzugt handelt es sich bei dem Festkörper um ein für Laserstrahlen zumindest teilweise transparentes Material. Es ist somit weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können. Ferner kann der Festkörper zusätzlich oder alternativ Siliziumcarbid (SiC) aufweisen oder daraus bestehen. Der Festkörper ist bevorzugt ein Ingot, der in einem Ausgangszustand, d.h. in einem Zustand vor dem Abtrennen des ersten Festkörperanteils, bevorzugt mehr als 5 kg oder mehr als 10 kg oder mehr als 15 kg oder mehr als 20 kg oder mehr als 25 kg oder mehr als 30 kg oder mehr als 35 kg oder mehr als 50 kg wiegt. Der Festkörperanteil ist bevorzugt eine Festkörperschicht, insbesondere ein Wafer mit mindestens 300mm Durchmesser.

Gemäß einer weiteren bevorzugten Ausführungsform der vorliegenden Erfindung reißt das Kristallgitter zumindest mehrheitlich in einem vom Zentrum der jeweiligen Modifikation beabstandeten Anteil ein. Diese Lösung ist besonders vorteilhaft, da hierdurch der Bedarf einer Nachbearbeitung des Teils des Festkörpers, an dem nach dem Trennen volumenmäßig weniger von der Modifikation bzw. von den Modifikationen verbleibt, reduziert wird.

Gemäß einer weiteren bevorzugten Ausführungsform der vorliegenden Erfindung erfolgt eine Konditionierung der Modifikationen, wobei das Kristallgitter erst durch die Konditionierung in den die Modifikationen umgebenden Bereichen zumindest in dem jeweils einen Anteil einreist.

Unterkritisch bedeutet hierbei, dass die Rissausbreitung zum Erliegen kommt bzw. stoppt bevor der Riss den Festkörper in mindestens zwei Teile teilt. Bevorzugt breitet sich ein unterkritischer Riss weniger als 5mm, insbesondere weniger als 1mm, in dem Festkörper aus. Die Modifikationen werden bevorzugt derart erzeugt, dass sich z.B. beim Abtrennen von ebenen Festkörperplatten die unterkritischen Risse bevorzugt mehrheitlich in derselben Ebene ausbreiten, insbesondere in einer zur Oberfläche des Festkörpers, durch welche die Laserstrahlen in den Festkörper eindringen, parallelen oder definiert ausgerichteten Ebene ausbreiten. Die Modifikationen werden bevorzugt derart erzeugt, dass sich z.B. beim Abtrennen von unebenen Festkörpern die unterkritischen Risse bevorzugt derart definiert, z.B. in einer sphärischen Lage bzw. Schicht ausbreiten, dass der Ablösebereich eine definierte, insbesondere sphärische, Form erhält.

Gemäß einer weiteren bevorzugten Ausführungsform der vorliegenden Erfindung wird zur definierten Temperierung die LASER-Strahlung mit einer Pulsdichte zwischen 100nJ/µm² und 10000 nJ/µm² bevorzugt zwischen 200nJ/µm² und 2000 nJ/µm² und besonders bevorzugt zwischen 500nJ/µm² und 1000 nJ/µm² in den Festkörper eingebracht.

Gemäß einer weiteren bevorzugten Ausführungsform der vorliegenden Erfindung weist die Aufnahmeschicht ein Polymer bzw. Polymermaterial auf oder besteht daraus, wobei das Polymer bevorzugt Polydimethylsiloxan (PDMS) oder ein Elastomer oder ein Epoxidharz oder eine Kombination daraus ist.

Gemäß einer weiteren bevorzugten Ausführungsform der vorliegenden Erfindung wird die Energie des Laserstrahls des Lasers, insbesondere fs-Lasers (Femtosekundenlaser), derart gewählt, dass die Stoffumwandlung im Festkörper bzw. im Kristall in zumindest einer Richtung kleiner oder größer als 30 mal, oder 20 mal oder 10 mal oder 5 mal oder dreimal die Reyleighlänge ist.

Die Wellenlänge des Laserstrahls des Lasers, insbesondere des fs-Lasers, wird gemäß einer weiteren bevorzugten Ausführungsform der vorliegenden Erfindung derart gewählt, dass die lineare Absorption des Festkörpers bzw. des Materials kleiner als 10 cm⁻¹ und bevorzugt kleiner als 1cm⁻¹ und besonders bevorzugt kleiner als 0,1cm⁻¹ ist.

Das Kristallgitter reist gemäß einer weiteren bevorzugten Ausführungsform der vorliegenden Erfindung zumindest mehrheitlich in einem vom Zentrum Z der jeweiligen Modifikation beabstandeten Anteil ein.

Der Riss geht gemäß einer weiteren bevorzugten Ausführungsform der vorliegenden Erfindung zumindest abschnittsweise durch die Mehrzahl, insbesondere die Gesamtheit, der Modifikationen hindurch oder verläuft zumindest zu der Mehrzahl, insbesondere zu der Gesamtheit, der Modifikationen beabstandet.

Eine erste Anzahl an Modifikationen wird gemäß einer weiteren bevorzugten Ausführungsform der vorliegenden Erfindung mit ihrem Zentrum Z einerseits des Ablösebereichs erzeugt und eine zweite Anzahl an Modifikationen wird mit ihrem Zentrum andererseits des Ablösebereichs erzeugt.

Der Festkörper ist gemäß einer weiteren bevorzugten Ausführungsform der vorliegenden Erfindung über eine Festkörperoberfläche mit einer Kühleinrichtung verbunden, wobei die Festkörperoberfläche, die mit der Kühleinrichtung verbunden ist, parallel oder im Wesentlichen parallel zu der Oberfläche ausgebildet ist, über welche die Laserstrahlen in den Festkörper eindringen, wobei die Kühleinrichtung in Abhängigkeit von der Laserbeaufschlagung, insbesondere in Abhängigkeit von der sich durch die Laserbeaufschlagung ergebenden Temperierung des Festkörpers, betrieben wird. Besonders bevorzugt liegt die Oberfläche, über die der Festkörper mit der Kühleinrichtung verbunden ist, genau gegenüber von der Oberfläche, über welche die Laserstrahlen in den Festkörper eindringen. Diese Ausführungsform ist vorteilhaft, da eine beim Erzeugen der Modifikationen erfolgende Temperaturzunahme des Festkörpers begrenzt oder reduziert werden kann. Bevorzugt wird die Kühleinrichtung derart betrieben, dass der durch die Laserstrahlen in den Festkörper eingebrachte Wärmeeintrag durch die Kühleinrichtung aus dem Festkörper entzogen wird. Dies ist vorteilhaft, da dadurch signifikant das Auftreten von thermisch induzierten Spannungen oder Verformungen reduziert werden kann.

Die Kühleinrichtung weist gemäß einer weiteren bevorzugten Ausführungsform der vorliegenden Erfindung mindestens eine Sensoreinrichtung zum Erfassen der Temperatur des Festkörpers auf und bewirkt in Abhängigkeit eines vorgegebenen Temperaturverlaufs eine Abkühlung des Festkörpers. Diese Ausführungsform ist vorteilhaft, da durch die Sensoreinrichtung sehr präzise eine Temperaturveränderung des Festkörpers erfasst werden kann. Bevorzugt wird die Veränderung der Temperatur als Dateninput zur Ansteuerung der Kühleinrichtung verwendet.

Die Kühleinrichtung ist gemäß einer weiteren bevorzugten Ausführungsform der vorliegenden Erfindung an einer Rotationseinrichtung angekoppelt und die Kühleinrichtung wird mit dem daran angeordneten Festkörper während der Modifikationserzeugung mittels der Rotationseinrichtung rotiert, insbesondere mit mehr als 100 Umdrehungen pro Minute oder mit mehr als 200 Umdrehungen pro Minute oder mit mehr als 500 Umdrehungen.

Gemäß einer weiteren bevorzugten Ausführungsform der vorliegenden Erfindung ist in zumindest zwei unterschiedlichen Bereichen des Festkörpers die Anzahl der erzeugten Modifikationen je cm² verschieden, wobei in einem ersten Bereich ein erster Block an Modifikationslinien erzeugt wird, wobei die einzelnen Modifikationen je Linie bevorzugt weniger als 10 µm, insbesondere weniger als 5 µm oder weniger als 3 µm oder weniger als 1 µm oder weniger als 0,5 µm, voneinander beabstandet erzeugt werden und die einzelnen Linien des ersten Blocks weniger als 20 µm, insbesondere weniger als 15 µm oder weniger als 10 µm oder weniger als 5 µm oder weniger als 1 µm, voneinander beabstandet erzeugt werden, wobei durch den ersten Bock an Modifikationen ein erster Teilablösebereich ausgebildet wird und in einem zweiten Bereich wird ein zweiter Block an Modifikationslinien erzeugt, wobei die einzelnen Modifikationen je Linie bevorzugt weniger als 10 µm, insbesondere weniger als 5 µm oder weniger als 3 µm oder weniger als 1 µm oder weniger als 0,5 µm, voneinander beabstandet erzeugt werden und die einzelnen Linien des zweiten Blocks weniger als 20 µm, insbesondere weniger als 15 µm oder weniger als 10 µm oder weniger als 5 µm oder weniger als 1 µm, voneinander beabstandet erzeugt werden, wobei durch den zweiten Bock an Modifikationen ein zweiter Teilablösebereich ausgebildet wird, wobei der erste Bereich und der zweite Bereich durch einen dritten Bereich voneinander beabstandet sind, wobei in dem dritten Bereich keine oder im Wesentlichen keine Modifikationen mittels Laserstrahlen erzeugt werden und der erste Bereich zum zweiten Bereich um mehr als 20 µm, insbesondere mehr als 50 µm oder mehr als 100 µm oder mehr als 150 µm oder mehr als 200 µm, beabstandet ist. Diese Ausführungsform ist vorteilhaft, da durch die lokale Erzeugung von Modifikationsblöcken derart große mechanische Spannungen in dem Festkörper erzeugt werden können, dass entweder ein lokales Einreißen des Festkörpers erfolgen kann oder infolge eines weiteren Auslöseevents, wie der thermischen Beaufschlagung einer am Festkörper angeordneten Aufnahmeschicht, ein Riss in dem Festkörper erzeugt wird. Es wurde erkannt, dass die Modifikationsblöcke bewirken, dass ein Riss auch in einem Bereich zwischen zwei Modifikationsblöcken stabil geführt wird. Dank der Modifikationsblöcke kann eine kontrollierte und sehr präzise Rissausbreitung mit weniger Modifikationen bewirkt werden. Dies hat erhebliche Vorteile, da die Bearbeitungszeit verkürzt wird, der Energieverbrauch reduziert wird und die Aufheizung des Festkörpers reduziert wird.

Bevorzugt werden die Modifikationen im ersten Block in Pulsabstände zwischen 0,01 µm und 10 µm erzeugt und/oder es werden Linienabstände zwischen 0,01 µm und 20 µm vorgesehen und/oder es wird eine Pulswiederholfrequenz zwischen 16kHz und 20 MHz vorgesehen.

Gemäß eines weiteren Aspekts der vorliegenden Erfindung wird in Abhängigkeit des Ortes, an dem eine Modifikation erzeugt wird, eine Optik, mittels der die Laserstrahlen von einer Laserstrahlenquelle zu dem Festkörper geleitet werden, angepasst, woraus zumindest eine Veränderung der numerischen Apertur bewirkt wird, wobei die numerische Apertur an einem Ort im Randbereich des Festkörpers kleiner ist als an einem anderen Ort des Festköpers, der näher zu dem Zentrum des Festkörpers liegt. Diese Ausführungsform ist vorteilhaft, da Modifikationen mit unterschiedlichen Eigenschaften erzeugt werden. Insbesondere im Randbereich, d.h. im Bereich bis zu 10 mm oder von bis zu 5 mm oder von bis zu 1 mm (in radialer Richtung) entfernt vom Rand, wird bevorzugt eine Optik verwendet, die eine Numerische Apertur zwischen 0,05 und 0,3, insbesondere von im Wesentlichen oder von genau 0,1, beträgt. Für die übrigen Bereiche wird bevorzugt eine Optik verwendet, bei der die Numerische Apertur zwischen 0,2 und 0,6 liegt, bevorzugt zwischen 0,3 und 0,5 und besonders bevorzugt im Wesentlichen oder genau 0,4 beträgt.

Gemäß einer weiteren bevorzugten Ausführungsform der vorliegenden Erfindung umfasst das thermische Beaufschlagen der Aufnahmeschicht eine Abkühlung der Aufnahmeschicht auf eine Temperatur von unter 20°C, insbesondere unter 10°C oder unter 0°C oder unter - 10°C oder unter 100°C oder auf oder unter die Glasübergangstemperatur des Materials der Aufnahmeschicht.

Durch die Temperierung werden Modifikationen bzw. wird die Stoffumwandlung mittels LASER erzeugt, wobei die Pulsabstände zwischen 0,01 µm und 10 µm, insbesondere mit 0,2 µm, vorgesehen werden und/oder Linienabstände zwischen 0,01 µm und 20 µm, insbesondere mit 3 µm, vorgesehen werden und/oder eine Pulswiederholfrequenz zwischen 16kHz und 20 MHz, insbesondere mit 128kHz, vorgesehen wird und/oder eine Pulsenergie zwischen 100nJ und 2000nJ, insbesondere mit 400nJ, vorgesehen wird. Besonders bevorzugt wird für das erfindungsgemäße Verfahren, insbesondere bei der Beaufschlagung von Siliziumcarbid, ein Piko- oder Femtosekundenlaser verwendet, wobei der LASER bevorzugt eine Wellenlänge zischen 800 nm und 1200 nm, insbesondere von 1030 nm oder 1060 nm, aufweist. Die Pulsdauer liegt bevorzugt zwischen 100 fs und 1000 fs, insbesondere bei 300 fs. Weiterhin wird bevorzugt ein Objektiv zur Fokussierung des Laserstrahls verwendet, wobei das Objektiv bevorzugt eine 20-100 fache Verkleinerung, insbesondere eine 50 fache Verkleinerung bzw. Fokussierung, des LASER-Strahls bewirkt. Ferner weist die Optik zum Fokussieren des Laserstrahls bevorzugt eine numerische Apertur von 0,1 bis 0,9, insbesondere von 0,65, auf.

Bevorzugt stellt jede durch die LASER-Strahlung bewirkte Stoffumwandlung eine Modifikation des Materials des Festkörpers dar, wobei die Modifikationen zusätzlich oder alternativ z.B. als Zerstörung des Kristallgitters des Festkörpers verstanden werden können. Gemäß einer weiteren bevorzugten Ausführungsform der vorliegenden Erfindung wird der Festkörper gegenüber der LASER-Lichtquelle bewegt, insbesondere verfahren, insbesondere rotiert. Bevorzugt erfolgt die Bewegung, insbesondere Rotation, des Festkörpers gegenüber der LASER-Lichtquelle kontinuierlich. Die dabei auftretenden Rotationsgeschwindigkeiten überschreiten bevorzugt 1 Umdrehung pro Sekunde oder 5 Umdrehungen pro Sekunde oder 10 Umdrehungen pro Sekunde bzw. einer Lineargeschwindigkeit von mindestens 100 mm/s. Der Festkörper ist hierzu bevorzugt an einem Rotationstisch bzw. Rotationschuck angeordnet, insbesondere angeklebt. Die Anzahl der Modifikationen je cm² der Festkörperoberfläche, durch welche die LASER-Strahlung zum Erzeugen der Modifikationen in den Festkörper eindringt, je Rotation liegt bevorzugt unter einer vorgegebenen Maximalanzahl, wobei sich die Maximalanzahl der Modifikationen je cm² und je Rotation bevorzugt in Abhängigkeit des Festkörpermaterials und/oder der Energiedichte der LASER-Strahlung und/oder in Abhängigkeit von der Dauer der LASER-Strahlungsimpulse bestimmt. Bevorzugt wird eine Steuerungseinrichtung bereitgestellt, welche in Abhängigkeit zumindest zweier oder dreier oder aller der zuvor genannten Parameter und bevorzugt weiterer Parameter, anhand vorgegebener Daten und/oder Funktionen die Maximalanzahl der zu erzeugenden Modifikationen je cm² je Rotation bestimmt. Dies ist insbesondere vorteilhaft, da erkannt wurde, dass schädliche vertikale Risse entstehen, wenn die Schädigungsdichte zu hoch ist, was aus Spannungen resultiert, die zwischen den bearbeiteten Bereichen und den noch nicht bearbeiteten Bereichen entstehen.

Zusätzlich oder alternativ werden bei aufeinanderfolgenden Rotationen des Festkörpers gegenüber der LASER-Lichtquelle die Modifikationen mit unterschiedlichen Mustern, insbesondere Abständen zwischen den einzelnen neu erzeugten Modifikationen und/oder mit veränderten Energieeintrag, insbesondere reduziertem Energieeintrag, erzeugt. Insbesondere kann entweder der Laser oder der Wafer bzw. Festkörper in XY-Richtung verschoben werden, wobei in Abhängigkeit der translatorischen XY-Verschiebung die Modifikationen erzeugt werden. Gemäß einer bevorzugten Ausführungsform wird ein XY-Tisch verwendet, auf welchem der Festkörper während des Betriebs des Lasers angeordnet ist. Bevorzugt wird durch die bereits genannte Steuerungseinrichtung oder eine alternative Steuerungseinrichtung die Optik, mittels der die LASER-Strahlen umgelenkt werden, kontinuierlich oder stufenweise, insbesondere in Abhängigkeit von einer Bewegung des Festkörpers, insbesondere von einer Drehung des Festkörpers, umjustiert bzw. neujustiert. Bevorzugt erfolgt aufgrund der Umjustierung bzw. Neujustierung eine gegenüber der vor dem Umjustieren bzw. Neujustieren eingestellten ersten LASER-Strahlenverlaufs eine Einstellung eines zweiten LASER-Strahlenverlaufs, der vom ersten LASER-Strahlenverlauf verschieden ist. Somit werden bevorzugt in Abhängigkeit von der Rotation des Festkörpers durch die Steuerungseinrichtung unterschiedliche LASER-Strahlenverläufe eingestellt. Besonders bevorzugt wird dabei jeweils die LASER-Scanrichtung umjustiert bzw. neujustiert bzw. verändert. Bevorzugt wird zusätzlich oder alternativ von der Steuerungseinrichtung die LASER-Lichtquelle, die Optik, insbesondere der Scanner, und/oder die den Festkörper verfahrende Einrichtung, insbesondere der Rotationstisch bzw. Rotationschuck, derart angesteuert, dass der Energieeintrag je Rotation gleich bleibt oder abnimmt, wobei der Energieeintrag in den Festkörper bevorzugt kontinuierlich, d.h. mit jeder Rotation, abnimmt oder stufenweise, d.h. jeweils nach mehreren Rotationen, abnimmt. Wobei bei einer stufenweisen Abnahme des Energieeintrags die Anzahl an Rotationen je Stufe voneinander verschieden sein können, so kann eine erste Stufe z.B. mehr als 2 Rotationen und eine andere Stufe mehr oder weniger Rotationen als die erste Stufe umfassen. Weiterhin ist denkbar, dass die Stufen jeweils dieselbe Anzahl an Rotationen umfassen. Ferner kann das Stufenverfahren auch mit dem kontinuierlichen Verfahren gemischt bzw. kombiniert sein.

Gemäß einer bevorzugten Ausführungsform kann der Laserstrahl eine Linie auch mehrmals mit Modifikationen beaufschlagen, so dass sich in einer Linie bzw. Zeile eine Gesamtmodifikation entsteht. Gemäß einer weiteren Alternative können sich die Linien bei der Beaufschlagung des Lasers zu Modifikationen kreuzen bzw. überlagern, wobei sich die erste Linie der Modifikationen insbesondere in einem vorbestimmten Winkel von beispielsweise 90°, 45°, 30°, 60° oder in einem anderen frei wählbaren Winkel schneiden können. Die Schnittwinkel zwischen Linien der Laserbeaufschlagung zur Erzeugung von Modifikationen können sich dabei an der Kristallausrichtung des Werkstoffs des Festkörpers orientieren, um die Effektivität der angebrachten Modifikationen zu erhöhen.

Zusätzlich oder alternativ ist die LASER-Lichtquelle als Scanner ausgebildet und die Erzeugung der Modifikationen erfolgt in Abhängigkeit von der Laserscanrichtung, der Laserpolarisationsrichtung und der Kristallorientierung. Bevorzugt wird durch die bereits genannte Steuerungseinrichtung oder eine alternative Steuerungseinrichtung, welche in Abhängigkeit zumindest zweier oder dreier der zuvor genannten Parameter und bevorzugt weiterer Parameter, anhand vorgegebener Daten und/oder Funktionen die zur Modifikationserzeugung erforderlichen Einrichtungen, insbesondere die LASER-Lichtquelle, die Optik, insbesondere der Scanner, und die den Festkörper verfahrende Einrichtung, insbesondere der Rotationstisch bzw. Rotationschuck, gesteuert.

Zusätzlich oder alternativ ist der Abstand zwischen den Zentren zweier nacheinander in Modifikationserzeugungsrichtung oder in Umfangsrichtung des Festkörpers erzeugter Modifikationen kleiner als 10000 nm, insbesondere kleiner als 1000 nm, insbesondere kleiner als 100 nm.

Zusätzlich oder alternativ sind die äußere Begrenzungen von nacheinander in Modifikationserzeugungsrichtung oder in Umfangsrichtung des Festkörpers erzeugten Modifikationen weniger als 10000 nm, insbesondere weniger als 1000 nm, insbesondere weniger als 100 nm, voneinander beabstandet.

Die vorliegende Erfindung kann sich ferner auf ein Verfahren zum Erzeugen eines Ablösebereichs in einem Festkörper zum Ablösen eines Festkörperanteils von dem Festkörper beziehen, das mindestens die nachfolgend genannten Schritte umfasst:
Bereitstellen eines zu bearbeitenden Festkörpers, Bereitstellen einer LASER-Lichtquelle, Beaufschlagen des Festkörpers mit LASER-Strahlung der LASER-Lichtquelle, wobei die LASER-Strahlung in dem Festkörper Modifikationen, insbesondere Kristallgitterdefekte, erzeugt, wobei eine Steuerungsvorrichtung zum Ansteuern der LASER-Lichtquelle und/oder einer den Festkörper verfahrende Einrichtung, insbesondere einen Rotationstisch bzw. Rotationschuck, und/oder einer Optik, insbesondere einem Scanner, in Abhängigkeit einzelner oder mehrerer bestimmter Parameter oder als Funktion einzelner oder mehrerer dieser Parameter vorgesehen ist.

Bevorzugt wird der Festkörper gegenüber der LASER-Lichtquelle rotiert und die Anzahl der Modifikationen je cm² der Festkörperoberfläche je Rotation, durch welche die LASER-Strahlung zum Erzeugen der Modifikationen in den Festkörper eindringt, unter einer vorgegebenen Maximalanzahl liegt, wobei sich die Maximalanzahl der Modifikationen je cm² und je Rotation bevorzugt in Abhängigkeit des Festkörpermaterials und der Energiedichte der LASER-Strahlung bestimmt und/oder bei aufeinanderfolgenden Rotationen des Festkörpers gegenüber der LASER-Lichtquelle die Modifikationen mit unterschiedlichen Mustern, insbesondere Abständen zwischen den einzelnen neu erzeugten Modifikationen, und/oder mit veränderten Energieeintrag, insbesondere reduziertem Energieeintrag, erzeugt werden, und/oder die LASER-Lichtquelle als Scanner ausgebildet ist und die Erzeugung der Modifikationen in Abhängigkeit von der Laserscanrichtung, der Laserpolarisationsrichtung und der Kristallorientierung erfolgt, und/oder der Abstand zwischen den Zentren zweier nacheinander in Modifikationserzeugungsrichtung oder in Umfangsrichtung des Festkörpers erzeugter Modifikationen kleiner als 10000 nm ist, insbesondere kleiner als 1000 nm, insbesondere kleiner als 100 nm ist,
und/oder die äußere Begrenzungen von nacheinander in Modifikationserzeugungsrichtung oder in Umfangsrichtung des Festkörpers erzeugten Modifikationen weniger als 10000 nm, insbesondere weniger als 1000 nm, insbesondere kleiner als 100 nm, voneinander beabstandet sind.

Bevorzugt bestimmt sich die maximal mögliche Anzahl der in einem Verfahrzyklus, insbesondere einer Rotation, des Festkörpers gegenüber der Optik, insbesondere einem Scanner, erzeugbaren Modifikationen durch eine Vielzahl an parallelen, insbesondere in radialer Richtung zu einander beabstandeten, Zeilen und den je Zeile maximal erzeugbaren Modifikationen. Gemäß einer bevorzugten Ausführungsform kann der Laserstrahl durch ein diffraktives optisches Element in eine Vielzahl von Laserstrahlen unterteilt werden, um somit gleichzeitig eine entsprechende Anzahl von Modifikationen gemäß der Aufteilung des Laserstrahls zu erzeugen. Bevorzugt umfasst die Vielzahl der Zeilen mindestens zwei und bevorzugt mindestens 10 und besonders bevorzugt bis zu 50 oder bis zu 100 oder bis zu 200 Zeilen. Hinsichtlich der erzeugten Muster ist dabei denkbar, dass bei einer bestimmten Anzahl an Zeilen in einem ersten Verfahrzyklus z.B. nur jede x-te Zeile oder jede x-te und y-te Zeile oder jede x-te und jede x-te minus z Zeile mit Modifikationen versehen wird. Konkret könnte zum Beispiel jede 5te Zeile mit Modifikationen versehen werden. Alternativ könnte jede 5te und jede 7te Zeile mit Modifikationen versehen werden. Alternativ kann z.B. jede 5te und jede 5te minus 2 mit Modifikationen versehen werden, was dann dazu führen würde, dass die 3te, 5te, 8te, 10te, 13te, 15te etc. Zeile mit Modifikationen versehen wird. Darüber hinaus ist es möglich, dass die Modifikationen blockweise erzeugt werden, das heißt, dass beispielsweise ein Block von 50 aufeinander folgenden Zeilen eine Modifikation enthält und die anschließenden 50 Zeilen keinerlei Modifikationen enthalten, wobei nach diesem Block von 50 Zeilen ohne Modifikation sich wiederum ein Block von 50 Zeilen mit Modifikation anschließt. Dies bedeutet, dass alternierend blockweise Modifikationen von einer Vielzahl von Zeilen vorgesehen sind. Gemäß einer weiteren Ausführungsform kann die Breite derartiger alternierender Blöcke entsprechend des Abstands vom Rand der Probe variieren, das heißt, dass beispielsweise im Bereich des Randes die Blöcke eine geringere Zeilenanzahl von Modifikationen aufweisen und zur Mitte der Probe hin eine höhere Zeilenanzahl von Modifikationen aufweisen. Zusätzlich oder alternativ ist denkbar, dass sich der Abstand zwischen den Zeilen, in denen Modifikationen erzeugt werden, in Abhängigkeit einer Funktion verändert. In einem zweiten Verfahrzyklus, der bevorzugt nach dem Ende des ersten Verfahrzyklus eintritt, insbesondere nach einer ersten Rotation, werden bevorzugt alternative Zeilen, die bevorzugt zueinander beabstandet sind, beschrieben. Im zweiten Verfahrzyklus und in den weiteren Verfahrzyklen, können dann für die Variablen x, y, z andere Zeilenzahlen vorgesehen sein. Ferner können mehr oder weniger Variablen vorgesehen sein. Zusätzlich oder alternativ kann der Abstand zwischen den einzelnen Modifikationen einer Zeile gemäß einem Muster erzeugt werden. Bevorzugt werden die Modifikationen in einer Zeile daher in einem ersten Verfahrzyklus, insbesondere einer ersten Rotation, z.B. nur an jeder a-ten Stelle (an der eine Modifikation vorgesehen ist) erzeugt oder an jeder a-ten und b-ten Stelle oder an jeder a-ten und jeder a-ten minus c Stelle erzeugt. Zusätzlich oder alternativ ist denkbar, dass sich der Abstand zwischen den Stellen, an denen Modifikationen erzeugt werden, in Abhängigkeit einer Funktion verändert. In einem zweiten Verfahrzyklus, der bevorzugt nach dem Ende des ersten Verfahrzyklus eintritt, insbesondere nach einer ersten Rotation, werden bevorzugt alternative Stellen, die bevorzugt zueinander beabstandet sind, beschrieben. Im zweiten Verfahrzyklus und in den weiteren Verfahrzyklen, können dann für die Variablen a, b, c andere Zeilenzahlen vorgesehen sein. Zusätzlich oder alternativ ist denkbar, dass sich die Zeilen die bearbeitet werden zumindest in Abhängigkeit einer Verfahrposition oder Verfahrstellung, insbesondere einer Rotationsstellung, und der Rotationsanzahl bestimmen und/oder die Stellen in einer Zeile, die bearbeitet werden (bzw. an denen Modifikationen erzeugt werden), zumindest in Abhängigkeit der Verfahrposition oder Verfahrstellung, insbesondere einer Rotationsstellung, und der Rotationsanzahl bestimmen. Insbesondere bei linearen Verfahrwegen des Festkörpers oder der Optik können auch zueinander geneigt, insbesondere rechtwinklig, stehende Zeilen oder Steifen an Modifikationen erzeugt werden.

Gemäß einer weiteren bevorzugten Ausführungsform stellt jede durch die LASER-Strahlung bewirkte Stoffumwandlung eine Modifikation des Materials des Festkörpers dar, wobei der Festkörper gegenüber der LASER-Lichtquelle translatorisch in XY-Richtung bewegt wird und die Anzahl der Modifikationen je cm² der Festkörperoberfläche, durch welche die LASER-Strahlung zum Erzeugen der Modifikationen in den Festkörper eindringt, wobei sich die Maximalanzahl der Modifikationen je cm² und gemäß der translatorischen Bewegung in XY-Richtung bevorzugt in Abhängigkeit des Festkörpermaterials und der Energiedichte der LASER-Strahlung bestimmt und/oder gemäß der translatorischen Bewegung in XY-Richtung des Festkörpers gegenüber der LASER-Lichtquelle die Modifikationen mit unterschiedlichen Mustern, insbesondere Abständen zwischen den einzelnen neu erzeugten Modifikationen, und/oder mit veränderten Energieeintrag, insbesondere reduziertem Energieeintrag, erzeugt werden, und/oder die LASER-Lichtquelle als Scanner ausgebildet ist und die Erzeugung der Modifikationen in Abhängigkeit von der Laserscanrichtung, der Laserpolarisationsrichtung und der Kristallorientierung erfolgt, und/oder der Abstand zwischen den Verschiebungen zweier nacheinander in Modifikationserzeugungsrichtung erzeugter Modifikationen kleiner als 10000 nm ist, insbesondere kleiner als 1000 nm ist, insbesondere kleiner als 100 nm ist, und/oder die äußere Begrenzungen von nacheinander in Modifikationserzeugungsrichtung erzeugten Modifikationen weniger als 10000 nm, insbesondere weniger als 1000 nm, insbesondere weniger als 100 nm, voneinander beabstandet sind.

Gemäß einer weiteren bevorzugten Ausführungsform erzeugt die LASER-Strahlung in dem Festkörper Modifikationen, insbesondere Kristallgitterdefekte, wobei der Festkörper gegenüber der LASER-Lichtquelle translatorisch bewegt wird und die Anzahl der Modifikationen je cm² der Festkörperoberfläche, durch welche die LASER-Strahlung zum Erzeugen der Modifikationen in den Festkörper eindringt, wobei sich die Maximalanzahl der Modifikationen je cm² und gemäß der translatorischen Bewegung in XY-Richtung bevorzugt in Abhängigkeit des Festkörpermaterials und der Energiedichte der LASER-Strahlung bestimmt und/oder gemäß der translatorischen Bewegung in XY-Richtung des Festkörpers gegenüber der LASER-Lichtquelle die Modifikationen mit unterschiedlichen Mustern, insbesondere Abständen zwischen den einzelnen neu erzeugten Modifikationen, und/oder mit veränderten Energieeintrag, insbesondere reduziertem Energieeintrag, erzeugt werden, und/oder die LASER-Lichtquelle als Scanner ausgebildet ist und die Erzeugung der Modifikationen in Abhängigkeit von der Laserscanrichtung, der Laserpolarisationsrichtung und der Kristallorientierung erfolgt, und/oder der Abstand zwischen den Verschiebungen zweier nacheinander in Modifikationserzeugungsrichtung erzeugter Modifikationen kleiner als 10000 nm ist, insbesondere kleiner als 1000 nm ist, insbesondere kleiner als 100 nm ist, und/oder die äußere Begrenzungen von nacheinander in Modifikationserzeugungsrichtung erzeugten Modifikationen weniger als 10000 nm, insbesondere weniger als 1000 nm, insbesondere weniger als 100 nm voneinander beabstandet sind.

Die Steuerungseinheit steuert die Erzeugung der Modifikationen zum Beispiel in Abhängigkeit der Anzahl der Verfahrzyklen und/oder der lokalen Wärmeentwicklung, die bevorzugt optisch und/oder mittels Sensoren erfasst wird, und/oder der Materialeigenschaften, insbesondere der Dichte und/oder der Festigkeit und/oder der Wärmeleitfähigkeit, des Festkörpers. Die Erfindung bezieht sich ferner auf ein Verfahren zum Abtrennen von mindestens einem Festkörperanteil von einem Festkörper, insbesondere einem Wafer, mindesten umfassend die Schritte: Anordnen einer Aufnahmeschicht an einem gemäß einem Verfahren nach einem der Ansprüche 1 bis 5 behandelten Festkörper, thermisches Beaufschlagen der Aufnahmeschicht zum, insbesondere mechanischen, Erzeugen von Rissausbreitungsspannungen in dem Festkörper, wobei sich durch die Rissausbreitungsspannungen ein Riss in dem Festkörper entlang dem Ablösebereich ausbreitet.

Die genannte Aufgabe wird bevorzugt erfindungsgemäß ebenfalls durch das nachfolgend genannte Verfahren gelöst. Das erfindungsgemäße Verfahren zum Abtrennen von mindestens einem Festkörperanteil von einem Festkörper, insbesondere einem Wafer, umfasst dabei mindestens die Schritte, des Modifizierens des Kristallgitters des Festkörpers mittels eines Modifikationsmittels, insbesondere eines Lasers, insbesondere eines Piko- oder Femtosekunden-Laser, wobei mehrere Modifikationen in dem Kristallgitter erzeugt werden, wobei das Kristallgitter in Folge der Modifikationen in den die Modifikationen umgebenden Bereichen zumindest in jeweils einem Anteil einreist, wobei durch die Risse im Bereich der Modifikationen ein Ablösebereich vorgegeben wird, des Anordnens einer Aufnahmeschicht an dem Festkörper zum Halten des Festkörperanteils, des thermischen Beaufschlagens der Aufnahmeschicht zum, insbesondere mechanischen, Erzeugen von Spannungen in dem Festkörper, wobei durch die Spannungen ein Hauptriss in dem Festkörper entlang dem Ablösebereich ausgelöst wird, wobei der Hauptriss den Festkörperanteil bevorzugt von dem Festkörper abtrennt.

Ferner wird die vorliegende Erfindung durch ein Verfahren zum Abtrennen von mindestens einem Festkörperanteil von einem Festkörper, insbesondere einem Wafer, gelöst. Das Verfahren umfasst dabei mindesten die Schritte: Modifizieren des Kristallgitters des Festkörpers mittels eines Modifikationsmittels, insbesondere eines Lasers, insbesondere eines Piko- oder Femtosekunden-Laser, wobei mehrere Modifikationen in dem Kristallgitter erzeugt werden, wobei in dem Kristallgitter durch die Modifikationen in jeweils mindestens einem eine Modifikation umgebenden Festkörperbereich derart Rissführungsspannungen erzeugt werden, dass ein den Festkörper trennender Riss durch die Rissführungsspannungen, insbesondere versetzt zum Zentrum der jeweiligen Modifikationen, geführt wird, wobei durch die Rissführungsspannungen im Festkörperbereich der Modifikationen ein Ablösebereich vorgegeben wird, Anordnen einer Aufnahmeschicht an dem Festkörper zum Halten des Festkörperanteils, thermisches Beaufschlagen der Aufnahmeschicht zum, insbesondere mechanischen, Erzeugen von Rissausbreitungsspannungen in dem Festkörper, wobei sich durch die Rissausbreitungsspannungen ein Riss in dem Festkörper entlang dem Ablösebereich ausbreitet.

Weitere Vorteile, Ziele und Eigenschaften der vorliegenden Erfindung werden anhand nachfolgender Beschreibung anliegender Zeichnungen erläutert, in welchen beispielhaft das erfindungsgemäße Trennverfahren dargestellt ist. Bauteile oder Elemente, die in dem erfindungsgemäßen Verfahren bevorzugt eingesetzt werden und/oder welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1: eine schematische Darstellung der erfindungsgemäßen laserbasierten Erzeugung einer Ablöseschicht in einem Festkörper;
- Fig. 2: eine schematische Darstellung eines bevorzugten Abtrennprozesses zum Abtrennen einer Festkörperschicht von einem Festkörper;
- Fig. 3: zwei mikroskopische Darstellungen der entlang des Ablösebereichs entstandenen Oberflächen der voneinander abgetrennten Festkörperteile;
- Fig. 4: eine Darstellung zum Nachweis des erfindungsgemäßen Effekts;
- Fig. 5a-5c: drei schematische Querschnittsdarstellungen, die jeweils Modifikationsblöcke in einem Festkörper zeigen;
- Fig. 5d-5e: zwei schematische Darstellungen jeweils entlang der Ablösebereiche geteilter Festkörper, wobei die Darstellung gemäß Fig. 5d keine Modifikationsreste zeigt und die Darstellung gemäß der Fig. 5e Modifikationsreste zeigt;
- Fig. 6a-c: drei schematische Darstellung von Modifikationsblöcken und den dadurch erzeugten lokalen Festkörperschwächungen oder lokalen Festkörperanrissen;
- Fig. 7a-c: drei schematische Darstellung von exemplarischen Rissverläufen;
- Fig. 8a-c: das mehrfache Abtrennen von Festkörperanteilen bzw. Festkörperschichten, insbesondere Wafern, von einem Festkörper;
- Fig. 9a-f: mehrere Schritte von der Bereitstellung des Festkörpers bis zur Rissauslösung infolge einer thermischen Beaufschlagung der Aufnahmeschicht;
- Fig. 10a: eine schematische Darstellung des Zustands nach der Festkörperanteilabtrennung;
- Fig. 10b: eine weitere Laserbeaufschlagung des Restfestkörpers zum Erzeugen von Modifikationen zum Abtrennen einer weiteren Festkörperschicht;
- Fig. 10c: eine schematische Darstellung des Restfestkörpers angeordnet an einer Kühleinrichtung, wobei die Kühleinrichtung an einer Verfahreinrichtung, insbesondere einem Rotationstisch, angeordnet ist;
- Fig. 10d: eine schematische Darstellung der Erzeugung von Modifikationen im Festkörper;
- Fig, 11: eine schematische Darstellung einer Kühleinrichtung, insbesondere eines Kühlchucks;
- Fig. 12: eine schematische Darstellung einer bevorzugt eingesetzten Optik;
- Fig. 13: eine schematische Darstellung überlagernder Strahlen bzw. Strahlenanteile bei der Erzeugung einer Modifikation im Festkörper
- Fig. 14a-14c: mikroskopische Aufnahmen von Kristallgittermodifikationen;
- Fig. 15a-15b: weitere mikroskopische Aufnahmen von Kristallgittermodifikationen;
- Fig. 16a-16b: noch weitere mikroskopische Aufnahmen von Kristallgittermodifikationen;
- Fig. 17a-17f: schematische Darstellungen von Modifikationen sowie dem Ablösebereich;
- Fig. 18a-18d: weitere schematische Darstellung von Modifikationen sowie dem Ablösebereich;
- Fig. 19a-19d: noch weitere schematische Darstellung von Modifikationen sowie dem Ablösebereich;
- Fig. 20: eine schematische Darstellung unterschiedlicher Modifikationskonzentrationen;
- Fig. 21: eine mikroskopische Darstellung einer Draufsicht auf die erzeugten Modifikationen durch die polierte Oberfläche des Festkörpers hindurch;
- Fig. 22a-22b: Darstellungen der Oberflächenstrukturen der durch den Riss voneinander getrennten Festkörperanteile und
- Fig. 23: eine weitere schematische Darstellung eines mittels Modifikationen veränderten Festkörpers.

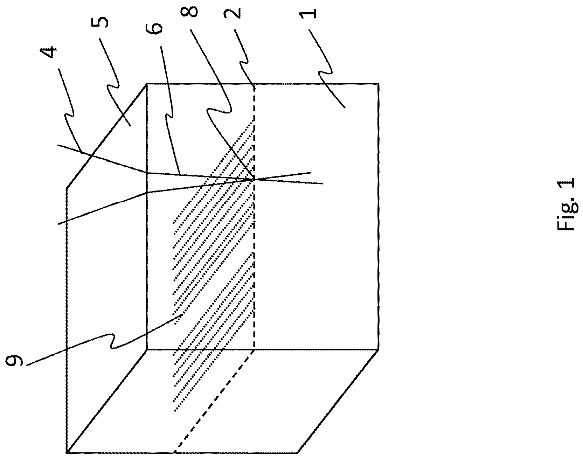

Das Bezugszeichen 1 kennzeichnet in Fig. 1 den Festkörper. In dem Festkörper 1 werden erfindungsgemäß Modifikationen 9 erzeugt, um einen Ablösebereich 2 auszubilden, an dem bzw. entlang dem der Festkörper 1 in mindestens zwei Bestandteile getrennt wird. Die Modifikationen 9 sind dabei Stoffumwandlungen bzw. Phasenumwandlungen des Festkörpermaterials, durch welche der Ablösebereich 2 geschaffen wird. Die Modifikationen 9 werden durch mindestens einen Laserstrahl 4 erzeugt. Der Laserstrahl 4 dringt über eine bevorzugt behandelte, insbesondere polierte, Oberfläche 5 in den bevorzugt zumindest teilweise transparenten Festkörper 1 ein. An der Oberfläche 5 wird der mindestens eine Laserstrahl bevorzugt gebrochen, was durch das Bezugszeichen 6 gekennzeichnet ist. Der mindestens eine Laserstrahl bildet dann einen Fokus 8 zur Erzeugung der Modifikation aus. Die polierte Oberfläche 5 kann auch als Hauptoberfläche 18 bezeichnet werden.

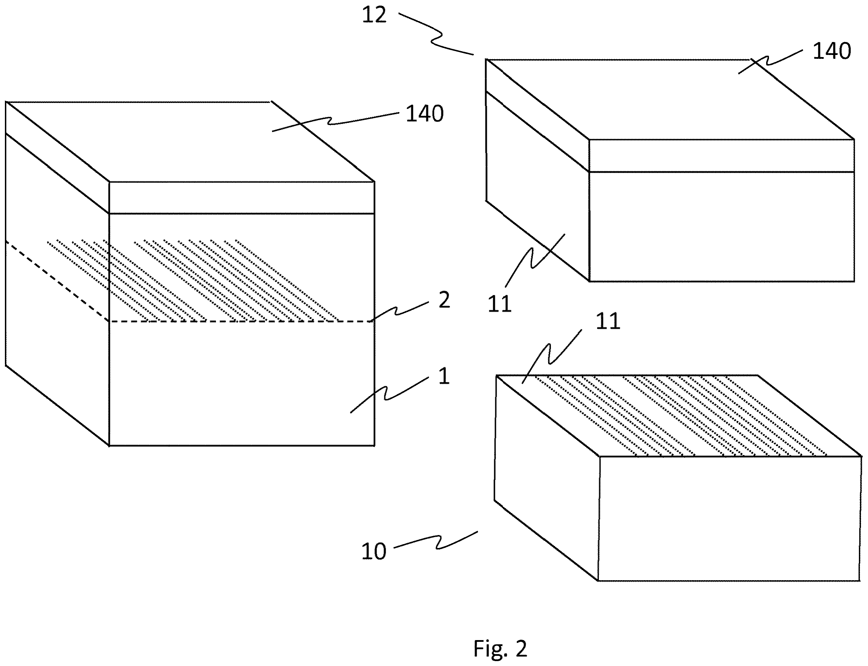

Fig. 2 zeigt ebenfalls den behandelten Festkörper 1, wobei auf mindestens einer Oberfläche des Festkörpers 1, insbesondere die Oberfläche 5 teilweise oder vollständig bedeckend oder überlagernd, eine Aufnahmeschicht 140 zur Einbringung von Spannungen in den Festkörper 1 angeordnet, insbesondere angebracht oder erzeugt, ist. Nach dem Abspalten der Festkörperschicht bzw. des Festkörperanteils vom Festkörper 1 verbleibt die Aufnahmeschicht 140 zunächst an dem abgespalteten Festkörperanteil und dient daher zu dessen Aufnahme. Die Aufnahmeschicht 140 besteht bevorzugt aus einem Polymerwerkstoff oder weist einen Polymerwerkstoff, insbesondere PDMS, auf. Infolge einer Temperierung, insbesondere Abkühlung, der Aufnahmeschicht 140 zieht sich die Aufnahmeschicht 140 zusammen und leitet dadurch Spannungen in den Festkörper 1 ein, durch die ein Riss ausgelöst und/oder zum Abtrennen des Festkörperanteils vom Festkörper 1 erzeugt und/oder geführt wird.

Die LASER-Beaufschlagung des Festkörpers 1 stellt besonders bevorzugt eine lokale Temperierung des Festkörpers 1, insbesondere im Inneren des Festkörpers 1, dar. Infolge der Temperierung verändert sich die chemische Bindung des Festkörpermaterials, wodurch eine Veränderung, insbesondere Herabsetzung, der Festigkeit bzw. Stabilität des Festkörpers 1 in dem beaufschlagten Anteil resultiert. Die LASER-Beaufschlagung erfolgt bevorzugt in einer gesamten den Festkörper 1 durchdringenden Ebene, wobei ebenfalls denkbar ist, dass mindestens oder maximal 30% oder 50% oder 60% oder 70% oder 80% oder 90% der den Festkörper 1 durchdringenden Ebene die erfindungsgemäße Modifikation erfahren.

Das Bezugszeichen 10 kennzeichnet einen ersten Festkörperanteil nach dem Durchtrennen des Festkörpers 1 und das Bezugszeichen 12 kennzeichnet den zweiten Festkörperanteil nach dem Durchtrennen des Festkörpers 1. Das Bezugszeichen 11 kennzeichnet ferner die Oberflächen, entlang der die zwei Festkörperanteile 10, 12 voneinander getrennt wurden.

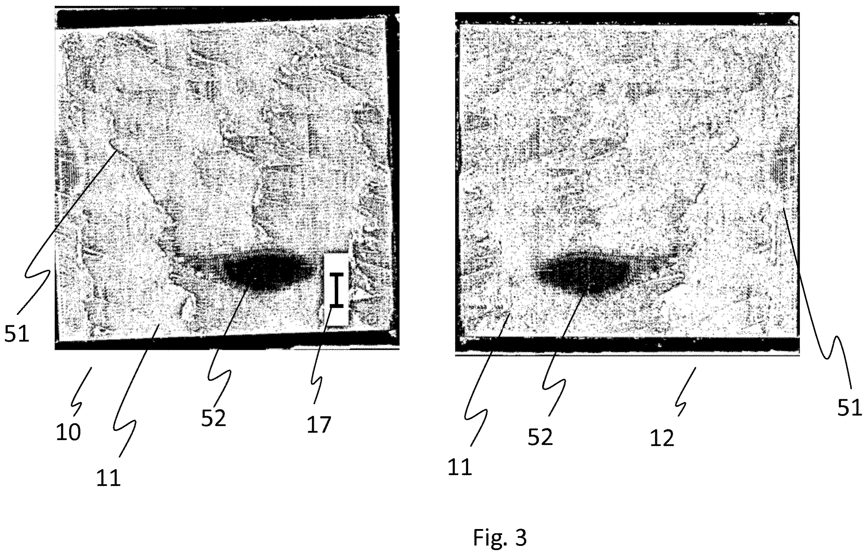

Fig. 3 zeigt eine Oberfläche 11 eines ersten Festkörperteils 10 und eines zweiten Festkörperteils 12, wobei der erste Festkörperteil 10 und der zweite Festkörperteil 12 entlang den Oberflächen 11 voneinander getrennt wurden. Weiterhin zeigt Fig. 3 einen unbehandelten Bereich 51 bzw. unbehandelten Anteil des Festkörpers 1 und einen behandelten Bereich 52 bzw. behandelten Anteil des Festkörpers 1. Der behandelte Anteil 52 ist durch die erfindungsgemäße LASER-Beaufschlagung entstanden und zeigt, dass sich das Material des Festkörpers 1 in diesem Bereich verändert hat bzw. umgewandelt wurde.

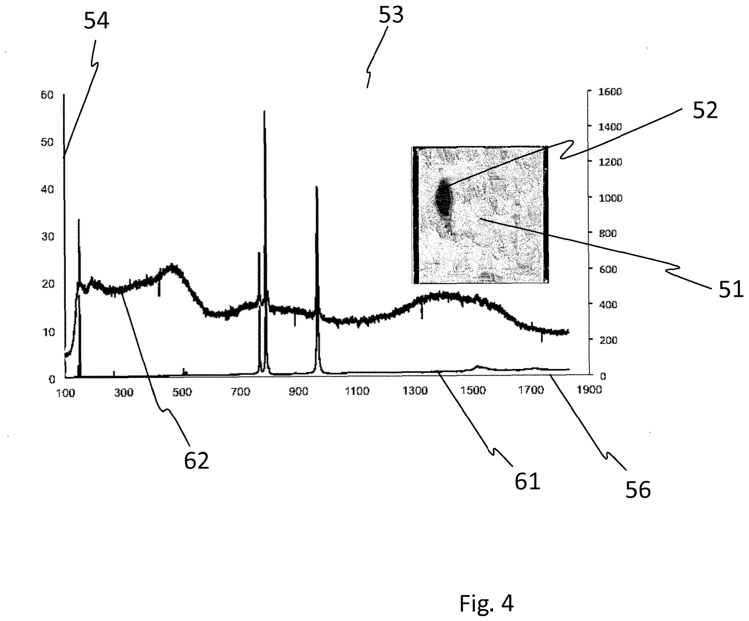

Fig. 4 zeigt ein Ramanspektrum (Bezugszeichen 53) 6H-SiC mit Konditionierung 1B nach der Abtrennung des Festkörperanteils 12. Das Bezugszeichen 54 kennzeichnet die Intensität in % und das Bezugszeichen 56 kennzeichnet die Wellenzahl in cm⁻¹. Weiterhin kennzeichnet das Bezugszeichen 61 den Graphen für den in Fig. 3 mit dem Bezugszeichen 51 gekennzeichneten unbehandelten Materialanteil und das Bezugszeichen 62 kennzeichnet den Graphen für den in Fig. 3 mit dem Bezugszeichen 52 gekennzeichneten behandelten Materialanteil. Es kann dem Ramanspektrum 53 entnommen werden, dass die durch die Bezugszeichen 51 und 52 gekennzeichneten Materialanteile unterschiedliche Materialeigenschaften aufweisen, insbesondere unterschiedliche Stoffe sind.

Die erfindungsgemäße LASER-Beaufschlagung bewirkt eine stoffspezifische ortsaufgelöste Kumulierung des Energieeintrags, woraus eine definierte Temperierung des Festkörpers 1 an einem definierten Ort oder an definierten Orten sowie in einer definierten Zeit resultiert. In einer konkreten Anwendung kann der Festkörper 1 aus Siliziumcarbid bestehen, wodurch bevorzugt eine stark lokal begrenzte Temperierung des Festkörpers 1 auf eine Temperatur von z.B. mehr als 2830 +/- 40°C vorgenommen wird. Aus dieser Temperierung resultieren neue Stoffe oder Phasen, insbesondere kristalline und/oder amorphe Phasen, wobei die resultierenden Phasen bevorzugt Si- (Silizium) und DLC- (Diamond-like carbon) Phasen sind, die mit deutlich verringerter Festigkeit entstehen. Durch diese festigkeitsreduzierte Schicht ergibt sich dann der Ablösebereich 2. Die Laserregelung erfolgt bevorzugt durch ortsaufgelöste Probentemperaturmessung zur Vermeidung von Randeffekten bei der Festkörper- bzw. Waferbearbeitung.

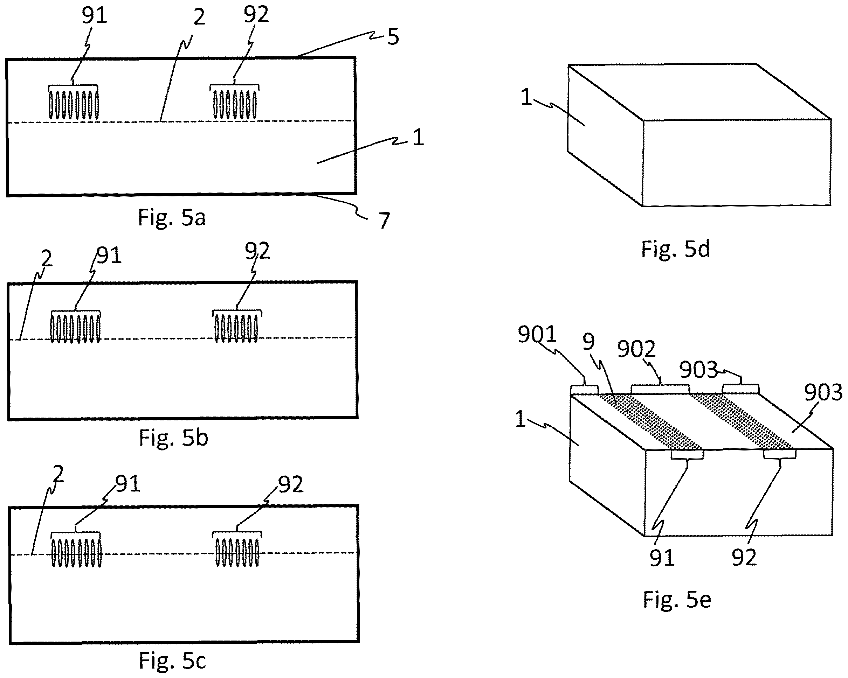

Fig. 5a zeigt, dass in zumindest zwei unterschiedlichen Bereichen des Festkörpers 1 die Anzahl der erzeugten Modifikationen je cm² verschieden ist. In einem ersten Bereich wird dabei ein erster Block 91 an Modifikationslinien erzeugt, wobei die einzelnen Modifikationen 9 je Linie bevorzugt weniger als 10 µm, insbesondere weniger als 5 µm oder weniger als 3 µm oder weniger als 1 µm oder weniger als 0,5 µm, voneinander beabstandet erzeugt werden. Die einzelnen Linien des ersten Modifikationsblocks 91 werden bevorzugt weniger als 20 µm, insbesondere weniger als 15 µm oder weniger als 10 µm oder weniger als 5 µm oder weniger als 1 µm, voneinander beabstandet erzeugt. Durch den ersten Bock 91 an Modifikationen 91 werden mechanische Spannungen in dem Festkörper 1 erzeugt.

In einem zweiten Bereich wird ein zweiter Block 92 an Modifikationslinien erzeugt wird, wobei die einzelnen Modifikationen 9 je Linie bevorzugt weniger als 10 µm, insbesondere weniger als 5 µm oder weniger als 3 µm oder weniger als 1 µm oder weniger als 0,5 µm, voneinander beabstandet erzeugt werden. Die einzelnen Linien des zweiten Blocks 92 werden bevorzugt weniger als 20 µm, insbesondere weniger als 15 µm oder weniger als 10 µm oder weniger als 5 µm oder weniger als 1 µm, voneinander beabstandet erzeugt. Durch den zweiten Bock 92an Modifikationen 92 werden mechanische Spannungen in dem Festkörper 1 erzeugt.

Der erste Bereich und der zweite Bereich sind durch einen dritten Bereich voneinander beabstandet, wobei in dem dritten Bereich keine oder im Wesentlichen keine Modifikationen 9 mittels Laserstrahlen erzeugt werden und der erste Bereich zum zweiten Bereich um mehr als 20 µm, insbesondere mehr als 50 µm oder mehr als 100 µm oder mehr als 150 µm oder mehr als 200 µm, beabstandet ist.

Die Modifikationen 9 werden hierbei bevorzugt über eine Oberfläche 5 der späteren Festkörperschicht 12 in den Festkörper 1 eingebracht. Der Abstand zwischen der Oberfläche 5, über welche die Laserstrahlen eingebracht werden, zu den Modifikationen 9 ist bevorzugt geringer als der Abstand von den Modifikationen 9 zu einer zur Oberfläche 5 beabstandeten und bevorzugt parallel ausgerichteten weiteren Oberfläche 7 des Festkörpers 1.

Es ist ersichtlich, dass der Ablösebereich 2 gemäß dieser Darstellung einerseits, insbesondere in Festkörperlängsrichtung unterhalb oder oberhalb, aller Modifikationen 9 liegt und bevorzugt beabstandet zu den Modifikationen 9 ist.

Fig. 5b zeigt einen ähnlichen Grundaufbau. Gemäß Fig. 5b erstreckt sich der Ablösebereich 2 jedoch durch die Modifikationen 9 hindurch.

Ferner zeigt Fig. 5c, dass der Ablösebereich 2 auch durch das Zentrum der Modifikationen 9 laufen kann.

Der Verlauf des Ablösebereichs 2 ist hierbei z.B. über die Anzahl der Modifikationen 9 und/oder die Größe der Modifikationen 9 und/oder den Abstand der einzelnen Modifikationen 9 eines Blocks 91, 92 einstellbar.

Fig. 5d zeigt den Restfestkörper 1 nach dem Abtrennen der Festkörperschicht 12 entlang dem in Fig. 5a gezeigten Ablösebereich 2. Da in diesem Fall die Modifikationen 9 vollständig von dem Restfestkörper 1 entfernt werden, zeigt der Restfestkörper 1 keine Reste dieser Modifikationen 9.

Der Fig. 5e hingegen lassen sich Reste der Modifikationen 9 entnehmen. Diese Modifikationsreste ergeben sich, wenn der Festkörper 1 entlang einem der in den Figuren 5b oder 5c gezeigten Ablösebereiche 2 abgetrennt wird. Ferner kann erkannt werden, dass die Modifikationsblöcke 91, 92 bevorzugt durch Felder 901, 902, 903 ohne Modifikationen bzw. mit weniger Modifikationen je cm2 voneinander beabstandet werden. Die Felder ohne Modifikationen 9 oder mit weniger Modifikationen 9 können hierbei bevorzugt kleiner oder größer sein als die Bereich, in denen die Modifikationsblöcke 91, 92 erzeugt werden. Bevorzugt sind zumindest einzelne, mehrere oder die Mehrzahl der Bereiche, in denen die Modifikationsblöcke 91 92 erzeugt werden, um ein Vielfaches, insbesondere um mindestens das 1,1 fache oder das 1,5 fache oder das 1,8 fache oder das 2 fache oder das 2,5 fache oder das 3 fache oder das 4 fache, größer als die Bereiche, in denen keine Modifikationen 9 oder weniger Modifikationen 9 erzeugt werden.

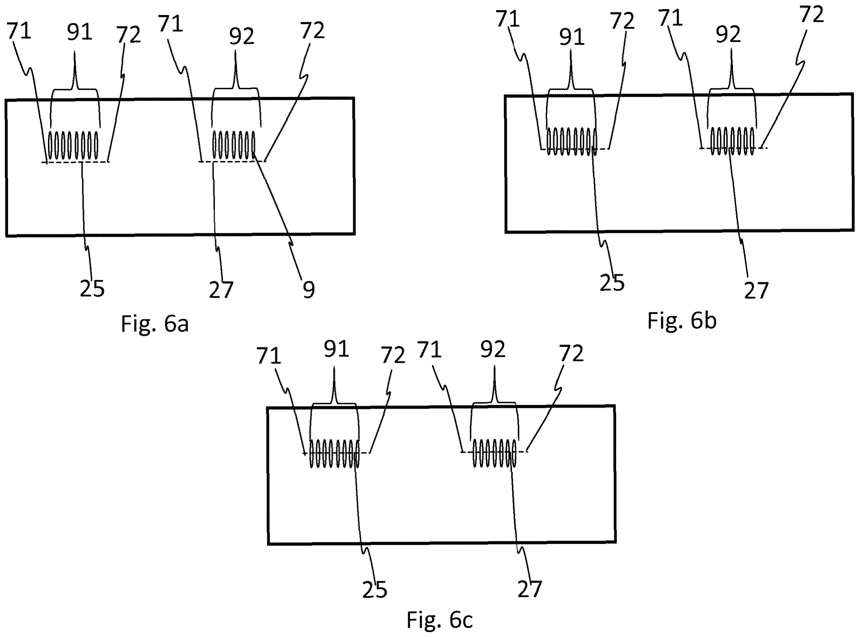

Die Figuren 6a-6c zeigen eine weitere Ausführungsform der vorliegenden Erfindung. Gemäß dieser Darstellungen dienen die Modifikationsblöcke 91, 92 zum Erzeugen von lokalen Materialschwächungen oder lokalen Festkörpereinrissen oder lokalen Spannungserhöhungen. Das Bezugszeichen 25 kennzeichnet hierbei einen ersten Teilablösebereich oder Rissanteil, in dem die lokalen Materialschwächungen oder lokalen Festkörpereinrissen oder lokalen Spannungserhöhungen auftreten, und das Bezugszeichen 27 kennzeichnet hierbei einen zweiten Teilablösebereich oder Rissanteil, in dem die lokalen Materialschwächungen oder lokalen Festkörpereinrissen oder lokalen Spannungserhöhungen ebenfalls auftreten. Die einzelnen Teilablösebereiche oder Rissanteile bilden bevorzugt Enden 71, 72 aus, über die der jeweilige Teilablösebereich oder Rissanteil hinaus vergrößert werden kann. Die Vergrößerung der Teilablösebereiche oder Rissanteile erfolgt bevorzugt infolge einer mittels der Aufnahmeschicht 140 (vgl. Fig. 2) bewirkten Krafteinleitung.

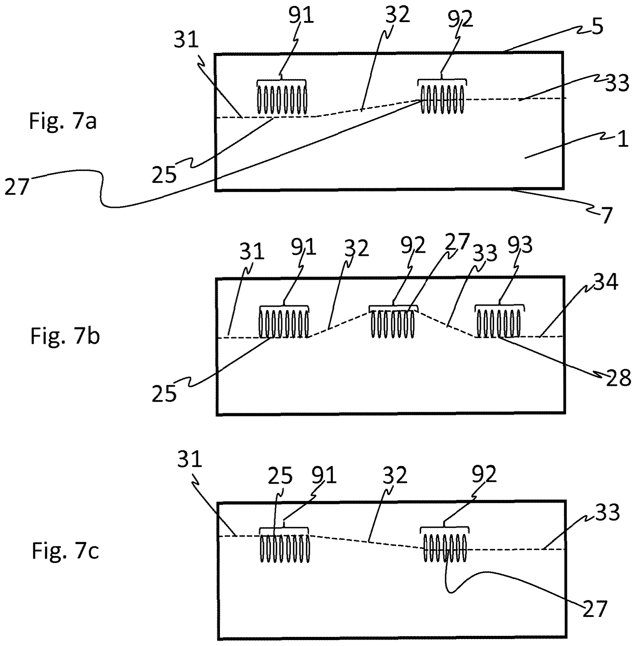

Die Figuren 7a bis 7c zeigen Ausführungsformen, gemäß denen der Verlauf des Ablösebereichs 2 infolge der Erzeugung der Modifikationsblöcke 91, 92, 93 derart gesteuert wird, dass vorbestimmte Muster oder Dickenveränderungen erzeugt oder kompensiert werden. Der Verlauf des Ablösebereichs 2 ist hierbei z.B. über die Anzahl der Modifikationen 9 und/oder die Größe der Modifikationen und/oder den Abstand der einzelnen Modifikationen 9 eines Blocks 91, 92, 93 einstellbar.

In Fig. 7a ist der Ablösebereich 2 durch die nachfolgend genannten Bestandteile gebildet: Riss 31 zwischen Außenkante und erstem Modifikationsblock 91, woran sich der erste Rissanteil 25, der unmittelbar durch den ersten Block 91 an Modifikationen 9 erzeugt wird, anschließt, woran sich Riss 32 zwischen den zwei Modifikationsblöcken 91 und 92 anschließt, woran sich der zweite Rissanteil 27 anschließt, der unmittelbar durch den zweiten Block 92 an Modifikationen 9 erzeugt wird, woran sich der Riss 33 zwischen dem Modifikationsblock 92 und der weiteren Außenkante des Festkörpers 1 anschließt. Es wird hierdurch ersichtlich, dass der Ablösebereich 2 derart vorgegeben werden kann, dass ein Riss zum Abtrennen der Festkörperschicht 12 von dem Festkörper 1, abschnittsweise auf verschiedenen Ebenen laufen kann.

Gemäß Fig. 7b ist ersichtlich, dass der Ablösebereich 2 derart gewählt werden kann, dass der Rissverlauf mehrere geometrische Wendepunkte enthält.

Fig. 7c zeigt rein exemplarisch eine weitere mögliche Ausgestaltung des Ablösebereichs 2.

Hinsichtlich der Figuren 7a-7c, ist festzuhalten, dass die Ausbildung von welligen Verläufen Vorteile bei der weiteren Behandlung der freigelegten Oberflächen, insbesondere bei nachgelagerten Schleif und/oder Polierschritten, bieten kann. Aufgrund der tatsächlich sehr geringen Höhe der Modifikationen 9 ist die tatsächliche Welligkeit, die hierrüber erzeugt wird nur sehr hochaufgelöst erfassbar. Mittels Modifikationsblöcken, wie z.B. den Blöcken 91, 92, 93, lässt sich der Riss jedoch sehr gut kontrolliert führen auch in den Bereichen, in denen keine oder weniger Modifikationen 9 erzeugt werden.

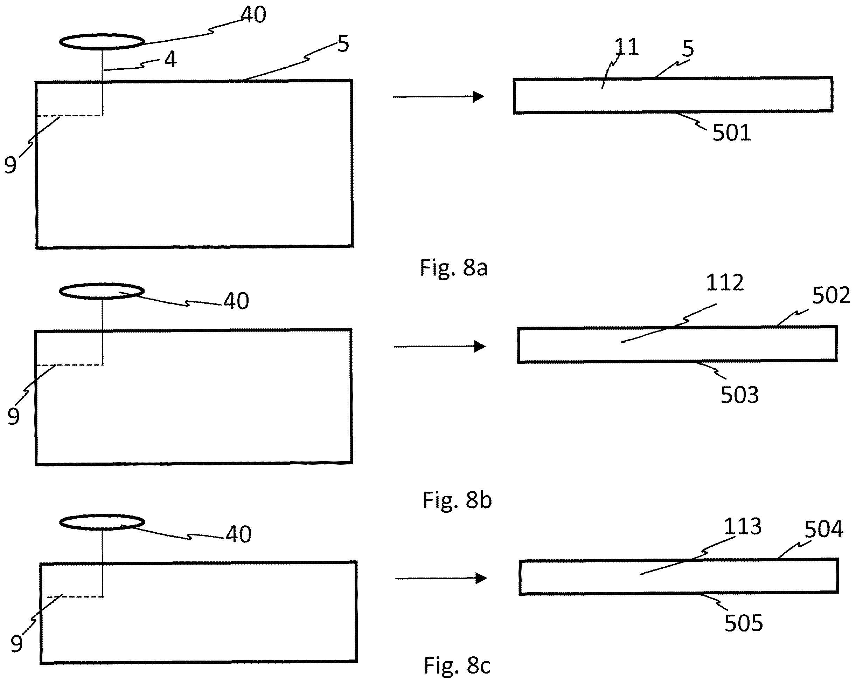

Die Figuren 8a-8c zeigen eine mehrfache Bearbeitung eines Festkörpers 1, insbesondere eines Ingots, wobei der Festkörper 1 jeweils um einen Festkörperanteil 12, insbesondere eine Festkörperschicht 12, gedünnt wird. In diesen Darstellungen sind eventuell anzubringende Aufnahmeschichten 140, wie in Fig. 2 gezeigt, nicht dargestellt. Im Sinne der vorliegenden Erfindung kann jedoch jeweils eine Aufnahmeschicht 140 zum Aufnehmen des Festkörpanteils 12 und zur Auslösung und/oder Unterstützung eines Risses ebenfalls an der Oberfläche 5, 502, 504 angeordnet werden.

Die Figuren 8a-8c zeigen somit jeweils das Beaufschlagen des Festkörpers 1 mit LASER-Strahlung der LASER-Lichtquelle, wobei die Laserstrahlen über eine Oberfläche 5, 502, 504 der abzutrennenden Festkörperschicht 12 in den Festkörper 1 eindringen. Durch die LASER-Strahlung wird ein vorgegebener Anteil des Festkörpers 1 im Inneren des Festkörpers 1 zur Ausbildung eines Ablösebereichs 2 oder mehrerer Teilablösebereiche definiert temperiert, die in dem vorgegebenen Anteil des Festkörpers 1 erzeugte Temperatur ist dabei bevorzugt so hoch, dass das den vorgegebenen Anteil ausbildende Material Modifikation 9 in Form einer vorbestimmten Stoffumwandlung erfährt. Die Anzahl und Anordnung der Modifikationen 9 ist dabei einstellbar und wird bevorzugt vorgegeben. Nach der Abtrennung des Festkörperanteils 12 wird eine erneute Beaufschlagung des Restfestkörpers 1 mit LASER-Strahlung der LASER-Lichtquelle durchgeführt, wobei die LASER-Strahlung einen vorgegebenen Anteil des Restfestkörpers 1 im Inneren des Restfestkörpers 1 zur Ausbildung eines Ablösebereichs 2 definiert temperiert, und die in dem vorgegebenen Anteil des Restfestkörpers 1 erzeugte Temperatur wiederum so hoch ist, dass das den vorgegebenen Anteil ausbildende Material eine vorbestimmte Stoffumwandlung erfährt. Somit können z.B. gleich, ähnlich oder verschieden dicke Festkörperanteile 12, insbesondere Festkörperschichten 12, insbesondere Wafer, von einem Festkörper 1 abgetrennt werden. Bevorzugt weist der Festkörper 1 eine solche Länge auf, dass eine Vielzahl, insbesondere mehr als 2 oder mehr als 5 oder mehr als 10 oder mehr als 20 oder mehr als 50 oder mehr als 100 oder mehr als 150 oder mehr als 200 Festkörperschichten 12 mit einer Dicke von weniger als 1000 µm, insbesondere von weniger als 800 µm oder von weniger als 500 µm oder von weniger als 300 µm oder von weniger als 200 µm oder von weniger als 150 µm oder von weniger als 110 µm oder von weniger als 75 µm oder von weniger als 50 µm, davon abtrennbar sind. Bevorzugt erfolgt nach jedem Abtrennen einer Festkörperschicht 12 eine spanende Bearbeitung der neu freigelegten Oberfläche 502, 504 des Restfestkörpers 1.

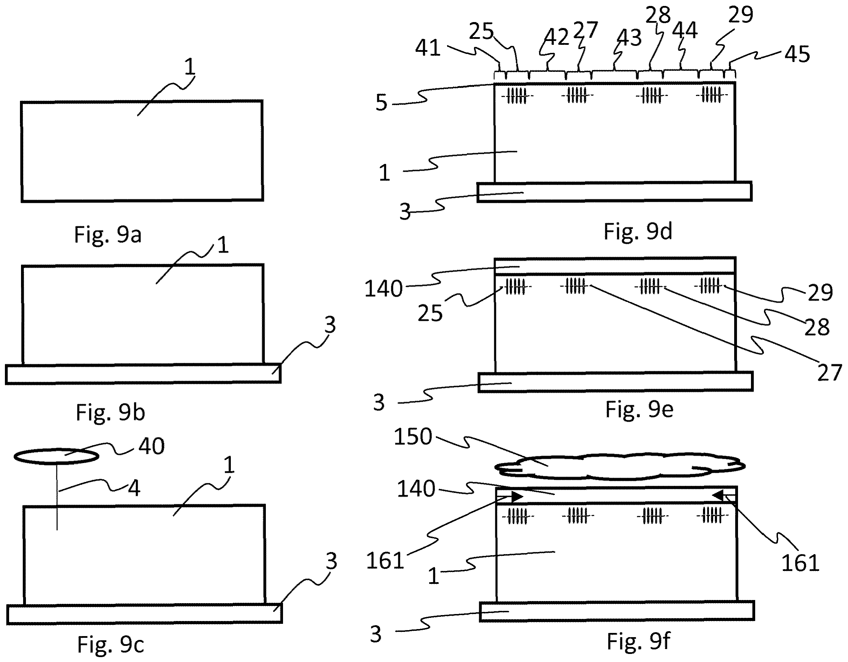

Die Figuren 9a-9f zeigen schematische Darstellungen unterschiedliche Prozesssituationen, wie sie gemäß dem erfindungsgemäßen Verfahren zum Herstellen von Festkörperschichten 12 auftreten können.

Fig. 9a zeigt die Bereitstellung des Festkörpers 1, insbesondere eines Ingots.

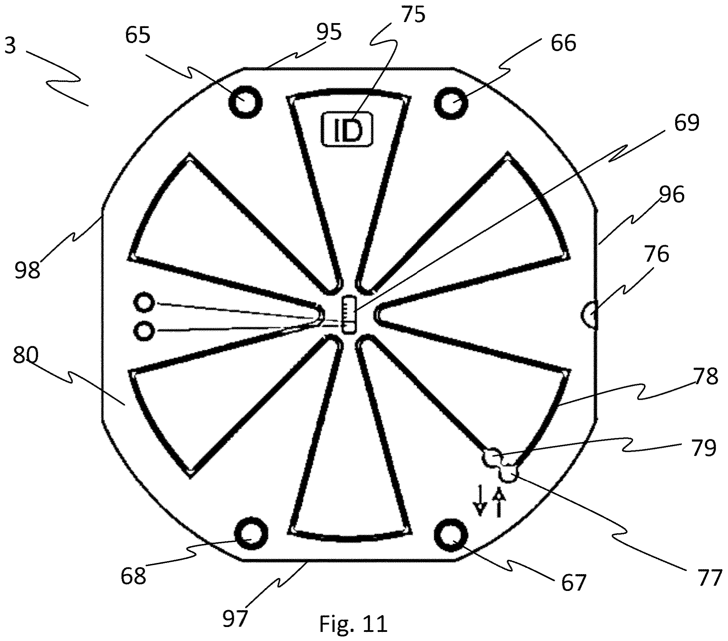

Gemäß Fig. 9b ist der bereitgestellte Festkörper 1 an einer Kühleinrichtung 3 angeordnet. Bevorzugt ist die Kühleinrichtung 3 ein Kühlchuck. Besonders bevorzugt wird der Festkörper 1 an einem Werkzeugträger (Chuck) angekoppelt bzw. angeklebt oder angeschweißt oder angeschraubt oder angeklemmt, wobei der Werkzeugträger bevorzugt eine Kühlfunktionalität umfasst und dadurch bevorzugt zur Kühleinrichtung 3 wird. Der Werkzeugträger besteht bevorzugt aus einer Legierung mit einer Zusammensetzung von 45%-60%, insbesondere 54%, Eisen, 20%-40%, insbesondere 29% Nickel und 10%-30%, insbesondere 17% Cobald. Die Prozentangaben beziehen sich hierbei auf den Anteil an der Gesamtmasse. Ein Beispiel für eine bevorzugte Kühleinrichtung 3 ist in Fig. 11 gezeigt. Der Festkörper 1 und die Kühleinrichtung 3 weisen bevorzugt die gleiche bzw. eine ähnliche Wärmeausdehnung auf. Als ähnliche Wärmeausdehnung wird hierbei bevorzugt jede Wärmeausdehnung bei einer Temperaturzunahme von 10°C in einem Temperaturbereich von -200°C bis 200°C verstanden, bei der die Differenz der Wärmeausdehnungen des Festkörpers 1 und der Kühleinrichtung 3 weniger als 50%, insbesondere weniger als 25% oder weniger als 10%, der Wärmeausdehnung des sich am stärksten ausdehnenden Objekts (Kühleinrichtung oder Ingot) beträgt. Die Wärmeausdehnung des Festkörpers 1 beträgt bevorzugt weniger als 10ppm/K, insbesondere weniger als 8ppm/K oder weniger als 5ppm/K, wie z.B. weniger als 4ppm/K oder im Wesentlichen 4ppm/K oder genau 4ppm/K.

Der Festkörper 1 wird bevorzugt in Längsrichtung mit seiner Unterseite 7, die bevorzugt in Längsrichtung gegenüber der Oberfläche 5 liegt, an der Kühleinrichtung 3 fixiert, insbesondere angeklebt. Die Laserstrahlen werden somit zum Erzeugen der Modifikationen 9 über die Oberfläche 5, die Bestandteil der abzutrennenden Festkörperschicht 12 ist, in Richtung der Kühleinrichtung 3 in den Festkörper 1 eingeleitet.

Fig. 9c zeigt schematisch die Erzeugung der Modifikationen 9 mittels der Laserstrahlen. Die Kühleinrichtung 3 bewirkt hierbei, dass die durch die Laserstrahlen in den Festkörper 1 eingebrachte Energie bzw. Wärme zumindest teilweise und bevorzugt mehrheitlich aus dem Festkörper 1 ausgeleitet wird.

Fig. 9d zeigt eine schematische Schnittdarstellung des Festkörper 1 nach der Erzeugung der Modifikationen 9. Gemäß diesem Beispiel sind 4 Blöcke an Modifikationen 9 erkennbar, die zu den 4 Rissanteilen 25, 27, 28, 29 führen. Angrenzend an die Blöcke mit Modifikationen 9 kennzeichnen die Bezugszeichen 41, 42, 43, 44 und 45 jeweils Bereiche ohne Modifikationen 9 oder Bereiche, in denen weniger Modifikationen 9 erzeugt sind, als in den Bereichen, in denen die Blöcke an Modifikationen 9 erzeugt sind.

Fig. 9e zeigt einen Zustand, gemäß dem eine Aufnahmeschicht 140, insbesondere ein Polymermaterial aufweisend, an der Oberfläche 5, über welche die Laserstrahlen in den Festkörper 1 eingedrungen sind, angeordnet oder erzeugt ist. Die Aufnahmeschicht 140 ist bevorzugt als Folie erzeugt worden und nach ihrer Erzeugung an die Oberfläche 5 angeklebt worden. Es ist jedoch ebenfalls möglich die Aufnahmeschicht 140 durch Aufbringung eines flüssigen Polymers auf die Oberfläche 5 und anschließendes Verfestigen auszubilden.

Fig. 9f zeigt schematisch eine Temperierung der Aufnahmeschicht 140. Bevorzugt wird die Aufnahmeschicht 140 auf eine Temperatur unterhalb der Umgebungstemperatur, insbesondere auf eine Temperatur von weniger als 20°C, oder von weniger als 1°C oder von weniger als 0°C oder von weniger als -10°C oder von weniger als -50°C oder von weniger als -100°C temperiert, insbesondere gekühlt. Wobei das Material der Aufnahmeschicht 140 infolge der Abkühlung einen Glasübergang erfährt. Bevorzugt erfolgt die Temperierung der Aufnahmeschicht 140 mittels flüssigen Stickstoffs. Aufgrund der Temperierung, insbesondere aufgrund des Glasübergangs, zieht sich die Aufnahmeschicht 140 zusammen, wodurch mechanische Spannungen in dem Festkörper 1 erzeugt werden. Aufgrund der mechanischen Spannungen wird ein die Rissanteile 25, 27, 28, 29 verbindender Riss ausgelöst, durch den der Festkörperanteil 12 von dem Festkörper 1 abgetrennt wird.

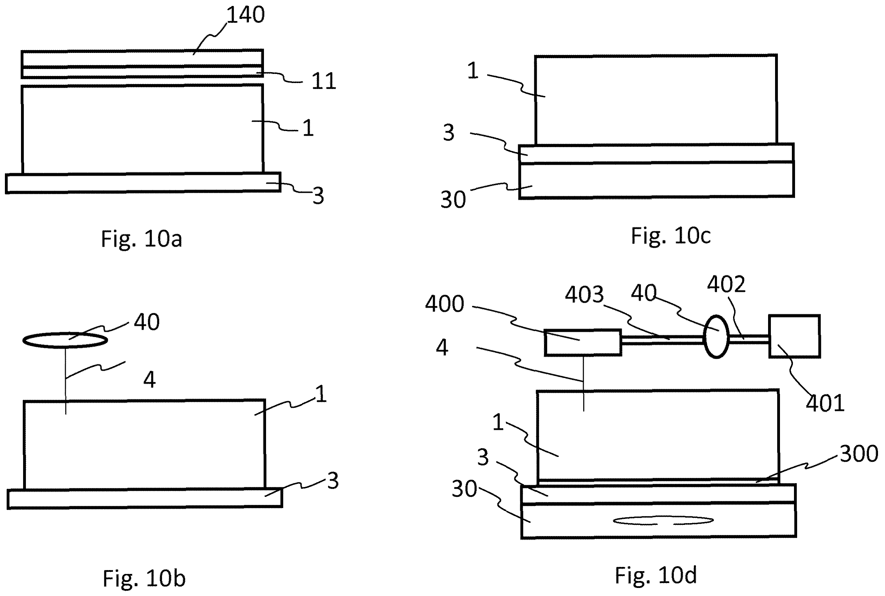

Fig. 10a zeigt eine Darstellung nach der in Fig. 9f gezeigten Temperierung der Aufnahmeschicht 140. Der Festkörperanteil 12 ist mit der weiterhin daran angeordneten Aufnahmeschicht 140 von dem Festkörper 1 abgetrennt.

Fig. 10b zeigt einen erneuten Schritt der Einbringung von Modifikationen 9 in den Restfestkörper 1, der zumindest um die bereits abgetrennte Festkörperschicht 12 in seiner Länge reduziert ist.

Fig. 10c zeigt schematisch eine weitere bevorzugte Ausgestaltung. Die Kühleinrichtung 3 ist hierbei einerseits mit dem Festkörper 1 gekoppelt und anderseits mit einer Verfahreinrichtung 30, insbesondere einer X-/Y-Verfahreinrichtung oder einem Rotationstisch, gekoppelt. Die Verfahreinrichtung 30 bewirkt eine Bewegung des Festkörpers 1, wodurch dieser gegenüber der Umgebung und einer Laseroptik, insbesondere einem Scanner, definiert bewegt werden kann.

Fig. 10d zeigt eine weiter detaillierte schematische Darstellung der Fig. 10c. Der runde Pfeil innerhalb der Verfahreinrichtung 30 kennzeichnet, dass diese rotierbar ist. Ferner ist zwischen dem Festkörper 1 und der Kühleinrichtung 3 eine Kopplungsschicht, insbesondere eine Klebeschicht, vorgesehen. Die Kopplungsschicht 30 ist hierbei bevorzugt derart ausgeführt, dass sie eine Vielzahl an Bearbeitungszyklen, insbesondere mehr als 200 oder mehr als 300 oder mehr als 500 Bearbeitungszyklen, bei hoher mechanischer und thermischer Belastung aushält. Ferner kann dieser Darstellung entnommen werden, dass die Laserstrahlenquelle 401 Laserstrahlen bevorzugt entlang eines ersten Laserstrahlenleiters 402 zu einer Optik 40 leitet, von wo aus die Laserstrahlen mittels eines weiteren Laserstrahlenleiters 403 zu einem Scanner gelangen. Es ist hierbei alternativ jedoch ebenfalls denkbar, dass zumindest die Laserstrahlenquelle 401 und der Scanner 400 vorgesehen sind.

Fig. 11 zeigt die Kühleinrichtung 3. Die Kühleinrichtung 3 weist bevorzugt eine Leit-Stütz-Struktur auf, die bevorzugt durch einen Werkzeugträger, insbesondere ein Chuck, gebildet wird. Die Leit-Stütz-Struktur weist bevorzugt eine runde Grundform auf. Dies ist vorteilhaft, da hinsichtlich Spinnprozessen leichter eine Unwucht vermieden werden kann. Ferner ist die runde Grundform bevorzugt mit Abflachungen 95-98 versehen. Diese Abflachungen sind vorteilhaft, da sie eine Grobausrichtung und/oder Kassettierung erlauben bzw. erleichtern.

Bevorzugt weist die Kühleinrichtung 3, insbesondere die Leit-Stütz-Struktur der Kühleinrichtung 3, eine gute Wärmeleitfähigkeit auf. Ferner weist die Kühleinrichtung 3 bevorzugt eloxiertes Aluminium auf, wodurch Abriebpartikel reduziert bzw. verhindert werden. Dies ist vorteilhaft, da dadurch die Reinraumkompatibilität erhöht wird. Ferner ist der Chuck bevorzugt kompatibel zum Ablöseprozess.

Ferner sind bevorzugt mindestens zwei Ausrichtelemente 65-68 vorgesehen. Bevorzugt sind die Ausrichtelemente 65-68 als Ausrichtlöcher oder Schlitze oder Zapfen ausgebildet. Die Ausrichtelemente 65-68 bilden bevorzugt Mitnehmer für die kraftschlüssige und/oder formschlüssige Rotationsübertragung aus. Bevorzugt weisen die Ausrichtelemente 65-68 Stahl- oder Keramikeinsätze auf, wodurch eine hohe Verschleißfestigkeit erzielt wird. Die Ausrichtelemente 65-68 dienen bevorzugt zum Koppeln der Kühleinrichtung 3 mit der Verfahreinrichtung 30.

Ferner können Passstifte vorgesehen sein, diese können z.B. als Niederhalter ausgeführt sein, wodurch z.B. ein Kraft und/oder Formschluss mit der Leit-Stütz-Struktur erzeugbar ist.

Weiterhin ist bevorzugt eine Kerbe, Nut oder Markierung 76 an der Kühleinrichtung 3 vorgesehen. Dieses Merkmal ist vorteilhaft, da dadurch die Festkörperorientierung, insbesondere Ingotorientierung, ersichtlich ist. Die Kenntnis über die Orientierung des Festkörpers, insbesondere des Ingots, kann ausgenutzt werden, um die mittels der Laserstrahlen erzeugten Modifikationen 9 an die kristallographische Orientierung anpassen zu können.

Das Bezugszeichen 75 kennzeichnet rein exemplarisch ein optionales Datenträgerelement und/oder Datenübertragungselement und/oder Datenerfassungselement. Bevorzugt ist das durch das Bezugszeichen 75 gekennzeichnete Element als Barcode und/oder RFID-Element und/oder SAW Sensor ausgeführt. Dies lässt insbesondere eine Integration in ein Manufacturing Execution System (MES) zu.

Ferner sind auf oder in der Leit-Stütz-Struktur bevorzugt Kühlkanäle zum Leiten eines Kühlfluids vorgesehen bzw. ausgebildet. Der oder die Kühlkanäle 78 können zur Temperierung des Festkörpers 1, der Kühleinrichtung 3 und/oder einer Maschinenhalterung, insbesondere der Verfahreinrichtung 30, dienen. In den Kühlkanal 78 kann über einen Einlass 77 Kühlfluid, insbesondere eine Flüssigkeit, zugeführt werden und über einen Auslass 79 entfernt werden. Die Grenzfläche bzw. die Kopplungsschicht zwischen Festkörper 1 und Kühleinrichtung 3 weist bevorzugt eine hohe thermische Leitfähigkeit, insbesondere entsprechend der thermischen Leitfähigkeit des Festkörpers 1 oder der Kühleinrichtung 3 auf. Die Kühleinrichtung 3 kann zusätzlich oder alternativ über die Luftgrenzfläche gekühlt werden. Bei hohen Drehzahlen bzw. Verfahrgeschwindigkeiten der Verfahreinrichtung 30 ist die sich um die Kühleinrichtung 3 herum ausbildende Luftschicht sehr dünn, wodurch Wärme sehr gut ableitbar ist.

Weiterhin ist bevorzugt eine aktive Thermostatierung in das MES integriert. Zusätzlich oder alternativ erfolgt eine Prozessüberwachung für unterschiedliche Substratgrößen und - dicken.

Bevorzugt erfolgt eine Abdichtung der Fluidkanäle bei fixer Lagerung mittels Anpressen und bei Rotation mittels z.B. einer zentralen Ringdichtung.

Das Bezugszeichen 69 kennzeichnet eine optionale Sensoreinrichtung, die bevorzugt als Temperatursensor ausgeführt ist. Bevorzugt handelt es sich bei der Sensoreinrichtung um einen SAW Temperatursensor.

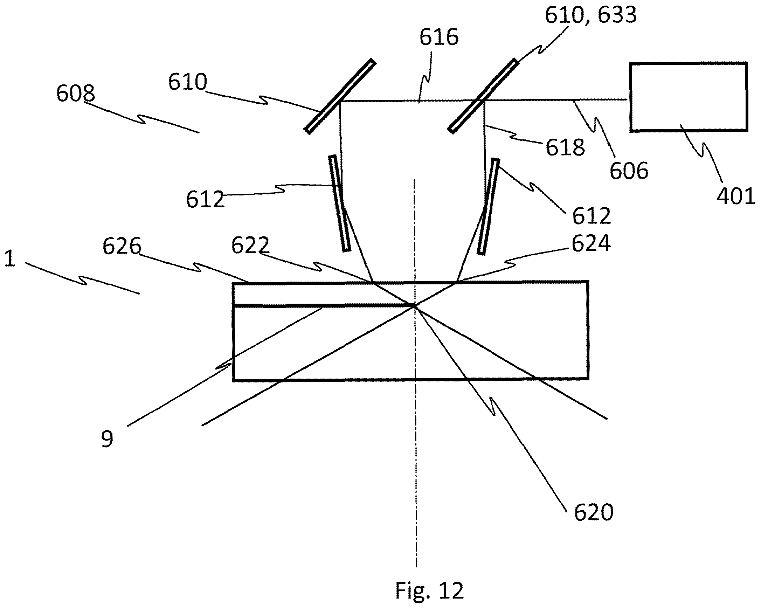

Fig. 12 zeigt die bevorzugt zur Erzeugung der Modifikationen 9 verwendete Optik 40, 608. Somit umfasst das erfindungsgemäße Verfahren bevorzugt ebenfalls den Schritt des Bereitstellens einer Optik 40, 608, wobei die Optik 608 bevorzugt mindestens zwei Umlenkelemente 610, 612 zum Umlenken von Lichtstrahlanteilen 616, 618 aufweist, Die Lichtstrahlen 616, 618 werden bevorzugt durch die Laserstrahlenquelle 401 erzeugt und emittiert. Ferner umfasst das erfindungsgemäße Verfahren bevorzugt den Schritt des Umlenkens zumindest zweier voneinander verschiedener Lichtstrahlanteile 616, 618 des emittierten Lichtstrahls 606 mittels der Umlenkelemente 610, 612, 613, wobei die Lichtstrahlanteile 616, 618 derart umgelenkt werden, dass sie in den Festkörper 1 eindringen und wobei die voneinander verschiedenen umgelenkten Lichtstrahlanteile 616, 618 in einem Fokus 620 innerhalb des Festkörpers 1 zusammentreffen und die physische Modifikation 9, insbesondere in Form eines Gitterdefekts, durch die im Fokus 620 zusammentreffenden Lichtstrahlenanteile 616, 618 erzeugt wird oder den Schritt des Erzeugens und Emittierens mindestens zweier Lichtstrahlen 606 durch die Laserstrahlenquelle bzw. Strahlungsquellenanordnung 401. Ferner umfasst das erfindungsgemäße Verfahren bevorzugt den Schritt des Umlenkens der Lichtstrahlen 606 mittels der Umlenkelemente 610, 612, 613, wobei die Lichtstrahlen 606 derart umgelenkt werden, dass sie in den Festkörper 1 eindringen und wobei die voneinander verschiedenen umgelenkten Lichtstrahlen 606 in einem Fokus 620 innerhalb des Festkörpers 1 zusammentreffen und die physische Modifikation 9, insbesondere in Form eines Gitterdefekts, durch die im Fokus 620 zusammentreffenden Lichtstrahlen (6) erzeugt wird.

Zusätzlich ist denkbar, dass zumindest zwei voneinander verschiedene Lichtstrahlanteile 616, 618 mindestens eines emittierten Lichtstrahls 606, insbesondere die Lichtstrahlenanteile mehrerer emittierter Lichtstrahlen, oder die mehreren emittierten Lichtstrahlen 606 mittels der Umlenkelemente 610, 612, 613 umgelenkt werden, wobei die Lichtstrahlanteile 616, 618 oder die Lichtstrahlen 606 derart umgelenkt werden, dass sie in den Festkörper 1 eindringen und wobei die voneinander verschiedenen umgelenkten Lichtstrahlanteile 616, 618 oder die voneinander verschiedenen umgelenkten Lichtstrahlen 606 in einem Fokus 620 innerhalb des Festkörpers 1 zusammentreffen und die physische Modifikation 9, insbesondere in Form eines Gitterdefekts, durch die im Fokus 620 zusammentreffenden Lichtstrahlenanteile 616, 618 oder Lichtstrahlen 606 erzeugt wird.

Weiterhin können gemäß dem erfindungsgemäßen Verfahren bei mehreren zeitgleich erzeugten Lichtstrahlen 606 mindestens zwei Lichtstrahlen 606 und bevorzugt alle Lichtstrahlen 606 in voneinander verschiedene, insbesondere unterschiedliche Wege zurücklegende, und an voneinander beabstandeten Oberflächenanteilen 622, 624 des Festkörpers 1 in den Festkörper 1 eindringende Lichtstrahlanteile 616, 618 aufgeteilt werden, wobei die Lichtstrahlanteile 616, 186 eines jeweiligen Lichtstrahls mittels voneinander verschiedener Umlenkelemente 610, 612, 613 umgelenkt werden.

Die Optik 608 weist bevorzugt mindestens ein Lichtstrahlaufspaltmittel 633, insbesondere einen Halbspiegel oder Strahlteiler, auf und mindestens ein Lichtstrahl 606 wird mittels mindestens dem Lichtstrahlaufspaltmittel 633 in mindestens zwei Lichtstrahlanteile 616, 618 aufgespalten. Bevorzugt wird ein Lichtstrahl 606 mittels einem Lichtstrahlaufspaltmittel 633, insbesondere einen Halbspiegel, in zumindest zwei Lichtstrahlanteile 616, 618 aufgespalten, wobei ein Lichtstrahlanteil 616 mittels mindestens zweier Umlenkelemente 610, 612, 613, insbesondere Spiegel, derart umgelenkt wird, dass er mit dem anderen Lichtstrahlanteil 618 im Inneren des Festkörpers 1 zum Bilden eines Fokus 620 zum Erzeugen der physischen Modifikation 9 zusammentrifft. Besonders bevorzugt wird eine Vielzahl physischer Modifikationen 9 erzeugt, wobei die physischen Modifikationen 9 bevorzugt eine Ebene und/oder eine Kontur und/oder eine Silhouette und/oder die äußere Gestalt eines Körpers bilden bzw. beschreiben.

Der mindestens eine von der Laserstrahlenquelle 401 emittierte Lichtstrahl 606 besteht bevorzugt aus kohärentem Licht und die Lichtwellen der im Fokus 620 zusammentreffenden Lichtstrahlanteile 616, 618 weisen bevorzugt die gleiche Phase und die gleiche Frequenz auf.

Besonders bevorzugt wird zumindest ein Lichtstrahlanteil 616, 618 oder zumindest ein Lichtstrahl 606 durch ein als Parabolspiegel ausgebildetes Umlenkelement 610, 612, 613 umgelenkt und fokussiert.

Ferner durchdringt der zumindest eine Lichtstrahlanteil 616, 618 oder der zumindest eine Lichtstrahl 606 vor der Umlenkung und Fokussierung bevorzugt ein Umlenkelement 610, 612, 613, insbesondere den Parabolspiegel, eine Strahlformungseinrichtung, insbesondere ein 1D-Teleskop, zum Verändern der Fokusform.

Durch die Laserstrahlenquelle 401 werden bevorzugt mindestens oder genau zwei Lichtstrahlen erzeugt, wobei die Lichtstrahlen 606 derart in Abhängigkeit von der Bandlücke des Materials des Festkörpers 1 mit voneinander verschiedenen Farben erzeugt werden, dass die Modifikation 9 durch einen Zwei-Photonen-Prozess erzeugt wird.

Bevorzugt wird durch einen ersten Lichtstrahl 606 ein erstes Laserfeld ausgebildet, wobei der erste Lichtstrahl 606 Photonen mit einer ersten Energie aufweist, und durch einen zweiten Lichtstrahl 606 wird bevorzugt ein zweites Laserfeld ausgebildet, wobei der zweite Laserstrahl 606 Photonen mit einer zweiten Energie aufweist, wobei das erste Laserfeld schwächer als das zweite Laserfeld ist und die erste Energie größer ist als die zweite Energie.

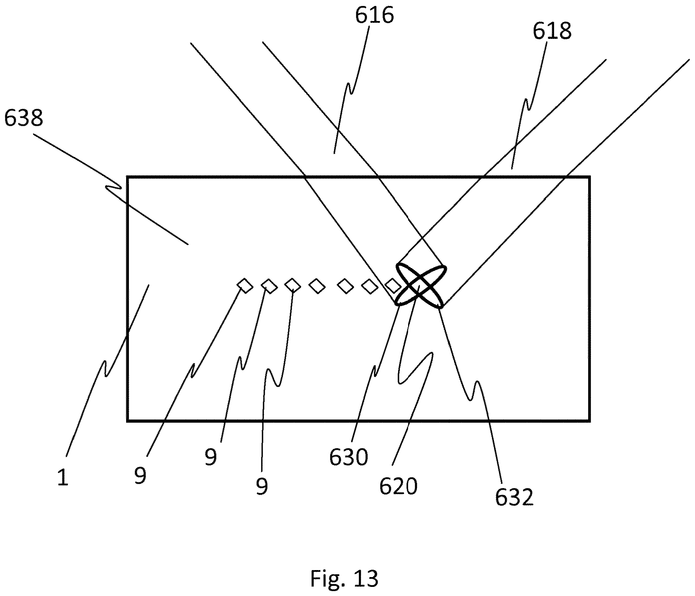

Fig. 13 zeigt die Modifikationserzeugung mittels zweier Laserstrahlen oder zweier Laserstrahlanteile in einer schematischen Darstellung. Die Modifikationen 9 weisen hierbei bevorzugt eine vertikale Ausdehnung von weniger als 50 µm und bevorzugt von weniger als 30 µm und besonders bevorzugt von weniger als 20 µm auf.

Der Fokus 620 ist bevorzugt weniger als 1000 µm und bevorzugt weniger als 500 µm und besonders bevorzugt weniger als 200 µm von einer Eindringoberfläche 626 des Festkörpers 1 beabstandet ist, wobei zumindest einzelne Lichtstrahlanteile 616, 618 über die Eindringoberfläche 626 zum Erzeugen der physischen Modifikation 9 in den Festkörper 1 eindringen.

Der Fokus 620 wird bevorzugt in einem Überlagerungsanteil von zumindest zwei sich kreuzenden Lichtstrahltaillen 630, 632 erzeugt, wobei die Lichtstrahltaillen 630, 632 durch die Lichtstrahlanteile 616, 618 oder Lichtstrahlen 606 erzeugt werden.

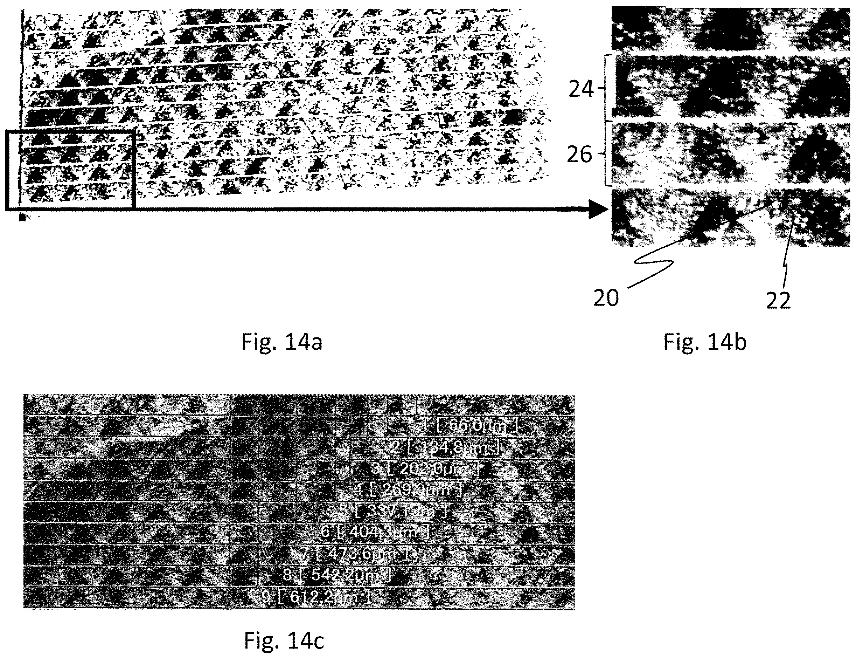

Fig. 14a bis 14c zeigen unterschiedliche mikroskopische Darstellungen eines mittels Laser konditionierten bzw. modifizierten Festkörpers 1, insbesondere mehrheitlich oder im Wesentlichen oder vollständig bestehend aus z.B. einem Halbleitermaterial, insbesondere aus SiC.

In Fig. 14a ist ein 6H-SiC-Liniendefekte-Feld 1E gezeigt, das mit Pulsabständen von 0,4 µm, Linienabständen von linenmäßig erzeugten Kristallgittermodifikationen 20, 22 von 2 µm und einer Pulswiederholfrequenz von 128 kHz erzeugt wurde. Es ist hierbei jedoch ebenfalls denkbar, dass einer der Parameter, mehrere dieser Parameter, insbesondere zwei dieser Parameter, oder alle dieser Parameter (Pulsabstände, Linenabstände, Pulswiederholfrequenz) variiert oder verändert festgelegt werden. So können die Pulsabstände z.B. zwischen 0,01 µm und 10 µm vorgesehen werden und/oder die Linienabstände zwischen 0,01 µm und 20 µm vorgesehen werden und/oder die Pulswiederholfrequenz zwischen 16kHz und 1024kHz vorgesehen werden.

In Fig. 14b ist eine vergrößerte Detaildarstellung des durch den Rahmen in Fig. 14a gekennzeichneten Bereichs dargestellt. Es ist erkennbar, dass die Blockabstände 24, 26 bevorzugt gleichmäßig ausgebildet sind und z.B. 66 µm betragen. Fig. 14c zeugt ebenfalls Blockabstände, die bei ca. 66 µm liegen. Es ist jedoch ebenfalls denkbar, dass die Blockabstände in anderen Bereichen liegen, wie z.B. im Bereich zwischen 4 µm und 1000 µm.

Die Darstellung der Fig. 14a stellt eine Draufsicht auf einen Festkörper durch eine polierte Oberfläche des Festkörpers dar. Die gezeigte Struktur ist somit innerhalb des Festkörpers ausgebildet bzw. durch die Modifikation, insbesondere mittels Laser, erzeugt worden.

Eine Rissbildung setzt in der dargestellten Konfiguration bevorzugt nicht ein.

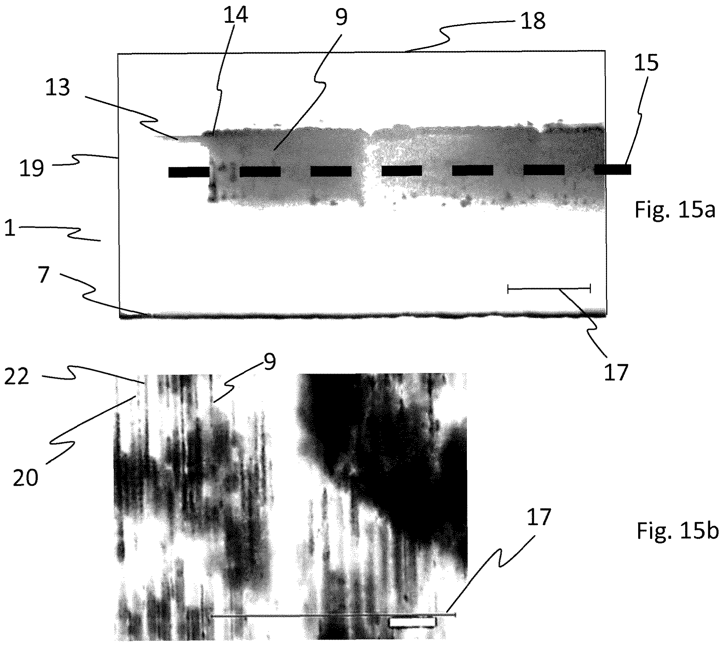

Die Figuren 15a und 15b zeigen mikroskopische Darstellungen von im Sinne der Erfindung modifizierten Festkörpern. In Fig. 15a kennzeichnet das Bezugszeichen 14 bevorzugt den Ort eines Bearbeitungsstarts, d.h. der Ort an dem bevorzugt die Modifikation des Kristallgitters des Festkörpers 1 begonnen wird. Das Bezugszeichen 9 kennzeichnet den modifizierten Bereich in dem Festkörper 1. Es ist aus dieser Darstellung ersichtlich, dass sich außermittig des modifizierten Bereichs 9 bzw. versetzt zum Zentrum 15 des modifizierten Bereichs 9 ein Riss 13 in dem Festkörper 1 ausbreitet. Es ist hierbei möglich, dass der Ort und die Richtung der Ausbreitung des Risses 13 durch definierte Parameter zur Erzeugung der Modifikation definiert vorgegeben werden, wobei der Riss 13 im gezeigten Beispiel bevorzugt parallel oder im Wesentlichen parallel zur Hauptoberfläche 18 verläuft. Der Riss 13 kann somit durch Parametereinstellung/en gezielt durch die Modifikationen 9 hindurch, am Rand der Modifikationen 9 oder beabstandet zu den Modifikationen 9 erzeugt bzw. ausgelöst und geführt werden.

Die Unterseite des Festkörpers 1, insbesondere des Wafers, wird durch das Bezugszeichen 7 angegeben. Ferner weist das Bezugszeichen 17 auf eine Referenzlänge hin, die bevorzugt 50 µm misst. Die gezeigte Querschnittsfläche erstreckt sich rechtwinklig zur Hauptoberfläche 18 des Festkörpers 1, d.h. über die Höhe der seitlichen Oberfläche 19, wobei bevorzugt über die Hauptoberfläche 18 die Modifikationen 9 in den Festkörper 1 eingebracht werden bzw. eine Erzeugung der Modifikationen 9 bevorzugt durch die Hauptoberfläche 18 hindurch bewirkt wird. Die Hauptoberfläche 18 ist besonders bevorzugt um ein Vielfaches, insbesondere mindestens doppelt oder mindestens dreifach oder mindestens vierfach oder mindestens 10 fach oder mindestens 20 fach oder mindestens 50-fach, größer als die seitliche Oberfläche 19.

Fig. 15a zeigt bevorzugt ein 6H-SiC-Liniendefekte-Feld 1C, das mit Pulsabständen von 0,2 µm, Linienabständen von linienmäßig erzeugten Kristallgittermodifikationen 20, 22 von 3 µm und einer Pulswiederholfrequenz von 128 kHz erzeugt wurde. Es ist hierbei jedoch ebenfalls denkbar, dass einer der Parameter, mehrere dieser Parameter, insbesondere zwei dieser Parameter, oder alle dieser Parameter (Pulsabstände, Linienabstände, Pulswiederholfrequenz) variiert oder verändert festgelegt werden. So können die Pulsabstände z.B. zwischen 0,01 µm und 10 µm vorgesehen werden und/oder die Linienabstände z.B. zwischen 0,01 µm und 20 µm vorgesehen werden und/oder die Pulswiederholfrequenz z.B. zwischen 16kHz und 1024kHz vorgesehen werden.

Fig. 15b zeigt eine Draufsicht auf einen Teil des Festkörpers 1 und durch die polierte Hauptoberfläche 18 hindurch auf die Modifikationen 9. Die einzelnen Modifikationen 9 sind gemäß dieser Darstellung derart erzeugt, dass mehrere von ihnen eine Linie 20, 22 bilden. Es ist hierbei jedoch ebenfalls denkbar, dass die Modifikationen zumindest teilweise in mehr als einer Richtung, insbesondere in zwei Richtungen, in mindestens zwei Richtungen oder in drei Richtungen homogen erzeugt werden. So werden die Modifikationen 9 besonders bevorzugt in einer zur Hauptoberfläche 18 parallelen ebene bevorzugt gleichmäßig bzw. homogen verteilt erzeugt. Es ist jedoch ebenfalls denkbar, dass in einer Richtung (Länge oder Breite oder Höhe) mehr Modifikationen 9 erzeugt werden als in einer oder zwei anderen Richtungen. Ferner ist denkbar, dass die Modifikationen 9 derart erzeugt werden, dass sie Muster darstellen. Weiterhin können die Modifikationen 9 im Sinne der vorliegenden Erfindung in verschiedenen Bereichen des Festkörpers 1, wobei die Bereiche bevorzugt dieselben Abmessungen aufweisen, in unterschiedlicher Anzahl und/oder mit unterschiedlichen Parametern erzeugt werden.

Das Bezugszeichen 17 kennzeichnet in Fig. 14b eine Referenzlänge, die bevorzugt 100 µm misst.

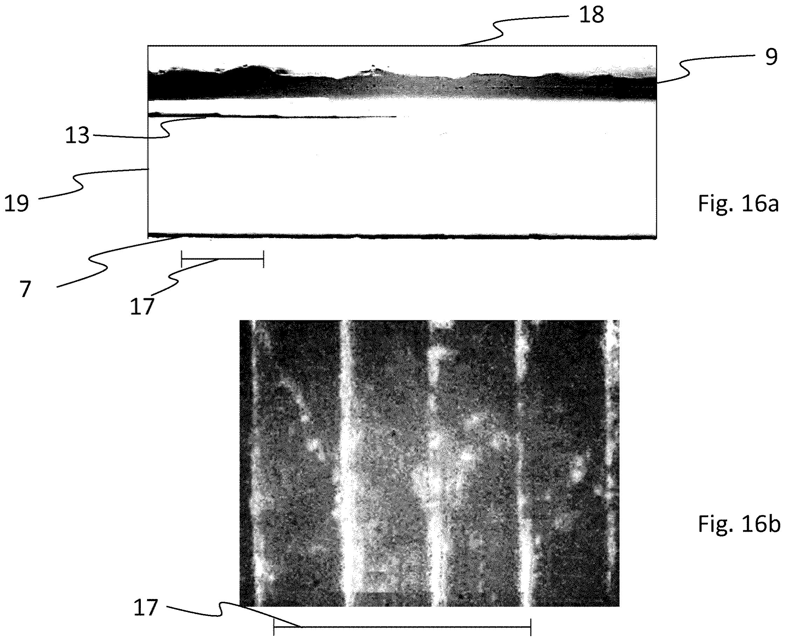

Fig. 16a zeigt bevorzugt ein 6H-SiC-Liniendefekte-Feld 1A, das mit Pulsabständen von 0,2 µm, Linienabständen von linienmäßig erzeugten Kristallgittermodifikationen 20, 22 von 1 µm und einer Pulswiederholfrequenz von 128 kHz erzeugt wurde. Es ist hierbei jedoch ebenfalls denkbar, dass einer der Parameter, mehrere dieser Parameter, insbesondere zwei dieser Parameter, oder alle dieser Parameter (Pulsabstände, Linienabstände, Pulswiederholfrequenz) variiert oder verändert festgelegt werden. So können die Pulsabstände z.B. zwischen 0,01 µm und 10 µm vorgesehen werden und/oder die Linienabstände z.B. zwischen 0,01 µm und 20 µm vorgesehen werden und/oder die Pulswiederholfrequenz z.B. zwischen 16kHz und 1024kHz vorgesehen werden.

Ferner kann Fig. 16a entnommen werden, dass sich beabstandet zu den erzeugten Modifikationen 9 ein Riss 13 in dem Festkörper 1 ausbreitet. Der Riss 13 breitet sich somit beabstandet zum Zentrum der Modifikationen 9 aus bzw. der Riss breitet sich in einem Bereich des Festkörpers 1 aus, der zu dem Hauptmodifikationsanteil beabstandet ist. Der Hauptmodifikationsanteil ist, z.B. bei durch LASER erzeugte Modifikationen 9, dabei bevorzugt der Anteil des Festkörpers 1, in dem der Laser seinen Fokus hat.

Das Bezugszeichen 17 kennzeichnet eine Referenzläng, die bevorzugt 100 µm beträgt.

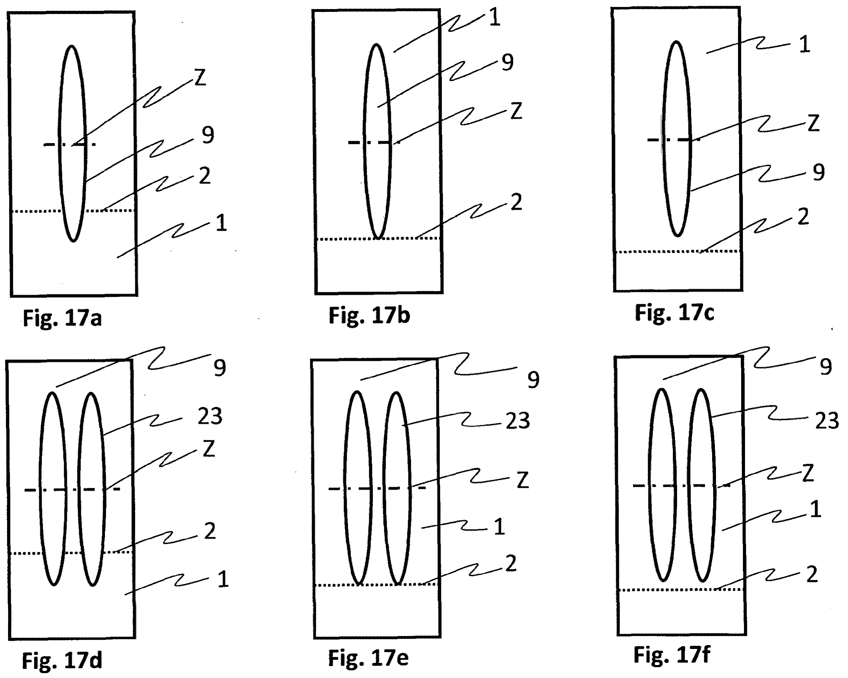

Die Figuren 17a bis 176f zeigen verschiedene Darstellungen des Modifikation-Risserzeugungs-Zusammenhangs. Fig. 6a zeigt beispielsweise eine z.B. entsprechend der Form einer Lasertaille geformte Modifikation 9. Es wird jedoch darauf hingewiesen, dass die Form der Modifikation 9 lediglich schematisch dargestellt ist. Ferner sind auch von der gezeigten Form abweichende Formen denkbar. So kann eine Modifikation 9 bevorzugt eine Form aufweisen, die im Gestaltungsraum zwischen einer sphärischen Form, insbesondere einem Kreis, und einem Vieleck, insbesondere einem Viereck, insbesondere einem Rechteck, wie z.B. einem Quadrat, liegt. Weiterhin zeigt die Fig. 6a, dass sich der Ablösebereich 2 nicht durch das Zentrum Z der Modifikation 9 erstreckt. Bevorzugt ist der Ablösebereich 2 um 1/20 oder 1/10 oder 1/5 oder 1/4 oder 1/3 oder die Hälfte der maximalen Länge der Modifikation 9 von dem Zentrum der Modifikation beabstandet.

Fig. 17b zeigt z.B. eine Variante, gemäß welcher der Ablösebereich 2 am äußeren Rand bzw. im Bereich des äußeren Randes der Modifikation 9 an der Modifikation 9 vorbeiläuft und die Modifikation daher besonders bevorzugt lediglich außen passiert jedoch nicht durch die Modifikation hindurch läuft.

Fig. 17c zeigt eine weitere Variante, gemäß welcher der Ablösebereich 2 bevorzugt um zumindest 0,01 µm oder um mindestens 0,1 µm oder um mindestens 1 µm oder um mindestens 5 µm oder um mindestens 10 µm von der Modifikation 9 beabstandet ist.

Die Figuren 6d bis 6f sind analog zu den Figuren 17a bis 17c aufgebaut. Die Figuren 17d bis 17e zeigen jedoch eine Variante, gemäß welcher der durch die Modifikation 9 erzielte Effekt, nämlich das lokale Durchtrennen des Kristallgitters des Festkörpers 1, erst durch das Zusammenwirken mehrerer Modifikationen 9, insbesondere von mindestens 2, 5, 10, 20, 50 oder von mindestens 100 Modifikationen, entsteht.

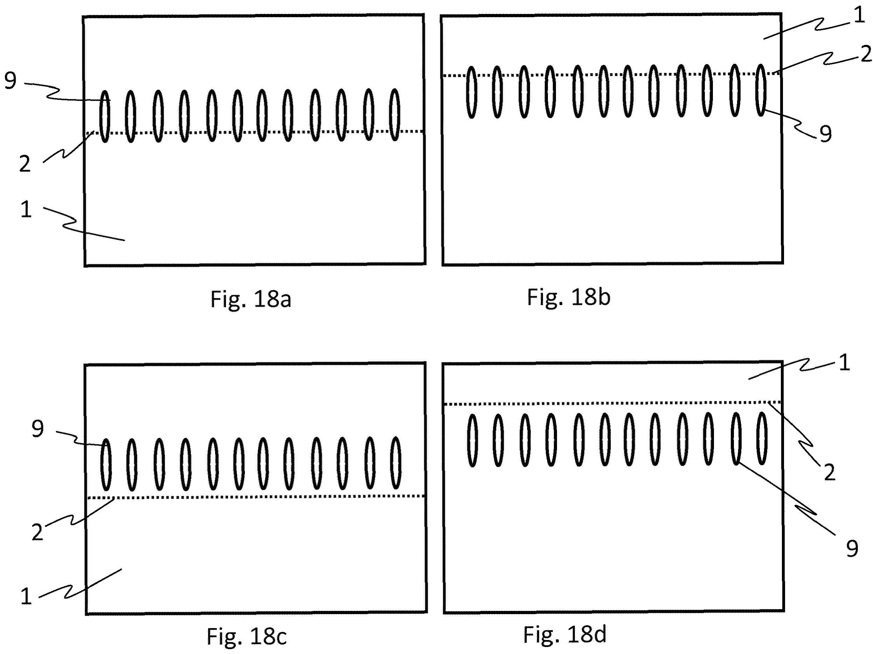

Die Figuren 18a bis 18d zeigen verschiedene Anordnungen von Modifikationen 9 und den aufgrund der Modifikation 9 sich ergebender Ablösebereiche 2. Je nach Bedarf können daher die zur Erzeugung der Modifikation erforderlichen Parameter derart eingestellt werden, dass der Ablösebereich 2 durch die Modifikationen 9 hindurch läuft (vgl. Fig. 18a und 18b) oder dass der Ablösebereich zu den Modifikationen 9 beabstandet ist. (vgl. Fig. 18c-18d).

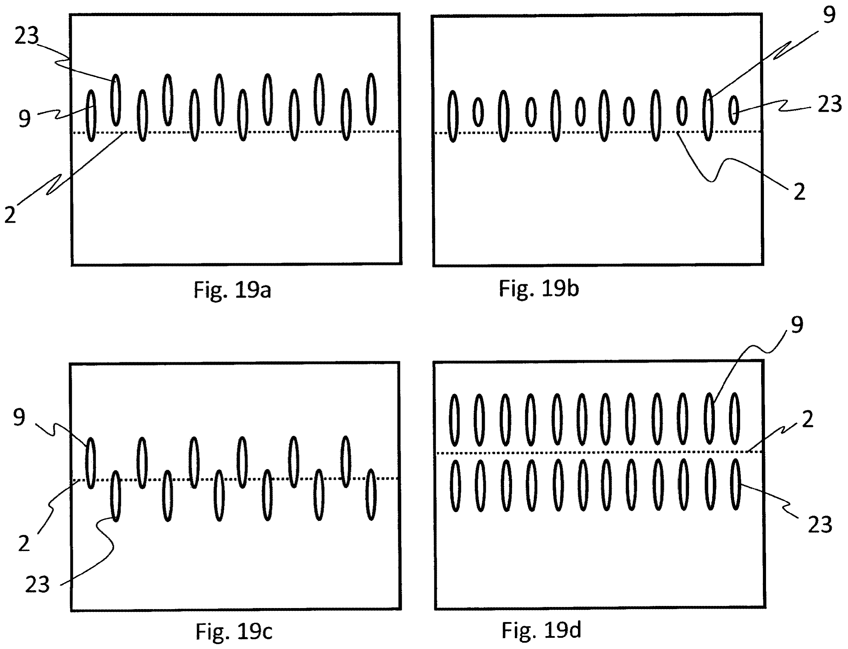

Die Figuren 19a-19d zeigen weitere Varianten, gemäß denen sich infolge der Erzeugung von Modifikationen 9 in einem Festkörper 1 ein Ablösebereich 2 ausbildet. Gemäß den Figuren 8a und 8b können die Zentren der Modifikationen 9 und 23 auf einer Seite des Ablösebereichs 2 vorgesehen sein. Es ist hierbei jedoch denkbar, dass die Modifikationen bis auf den Ort ihrer Erzeugung (insbesondere der Abstand zur Hauptoberfläche) identisch erzeugt werden. Ferner ist denkbar, dass sich zusätzlich oder alternativ zu dem Ort der Modifikationen 9, 23 der Fokus und/oder die Energiemenge und/oder die Beaufschlagungszeit, etc. ändert. In den Figuren 19c bis 19d sind die Zentren der Modifikationen 9 und 23 jeweils auf verschiedenen Seiten des Ablösebereichs 2.

Es ist hierbei denkbar, dass die Zentren der Modifikationen 9, 23 im gleichen Abstand oder in verschiedenen Abständen zum Ablösebereich 2 ausgebildet werden. Ferner ist denkbar, dass sich zusätzlich oder alternativ zu dem Ort der Modifikationen 9, 23 der Fokus und/oder die Energiemenge und/oder die Beaufschlagungszeit, etc. ändert bzw. unterschiedlich eingestellt wird.

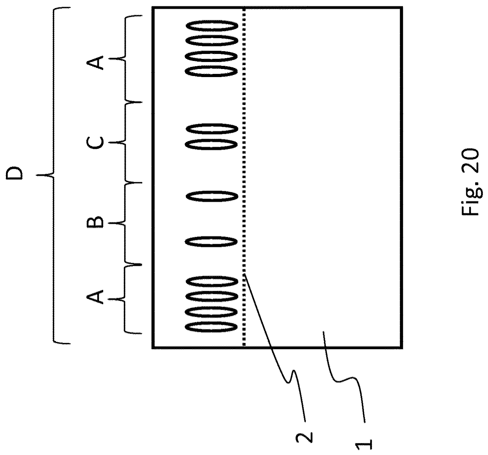

Fig. 20 zeigt eine Anordnung, gemäß der die Modifikationen 9 lokal in unterschiedlichen Konzentrationen (A-D) und/oder Verteilungen erzeugt werden. Es ist hierbei z.B. denkbar, dass zur Auslösung eines die einzelnen Risse verbindenden Hauptrisses lokal unterschiedliche Modifikationskonzentrationen oder Verteilungen vorgesehen werden. Bevorzugt werden im Bereich einer Hauptrissauslösestelle mehr Modifikationen erzeugt bzw. es wird eine höhere Modifikationendichte vorgesehen.

Es wird ferner darauf hingewiesen, dass die einzelnen in den Figuren 17a-17f, 18a-18d, 19a-19d, 20 gezeigten Varianten bevorzugt miteinander kombinierbar sind.

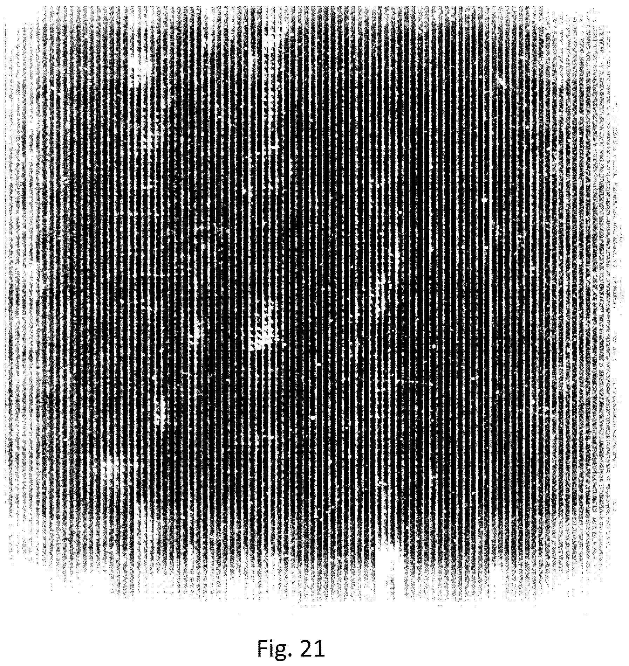

Fig. 21 zeigt eine Draufsicht auf ein 6H-SiC-Liniendefekte-Parameterfeld 1C, wobei bevorzugt eine Laserschädigung von 1 cm² und eine Dicke von 245+/-3 µm vorliegen. Die Draufsicht erfolgt durch die polierte Hauptoberfläche des Festkörpers 1 und zeigt einen Zustand vor dem Abtrennen einer Festkörperschicht 11 entlang des Ablösebereichs 2.

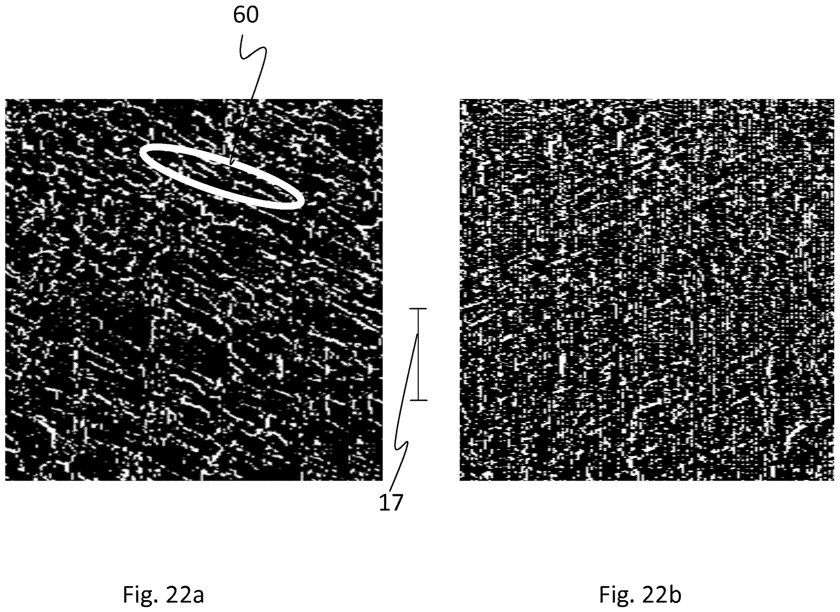

Fig. 22a und 22b zeigen bevorzugt zwei Ansichten eines 6H-SiC-Liniendefekte-Parameterfeld 1C, wobei bevorzugt eine Laserschädigung von 1 cm² und eine Dicke von 120 +/-3 µm vorliegen. Die beiden gezeigten Oberflächenstrukturen sind durch die Trennung des Festkörpers 1 in zwei Teile entstanden. Das Bezugszeichen 60 kennzeichnet hierbei sich in bzw. im Wesentlichen in horizontaler Richtung erstreckende Risse. Ferner zeigt die Fig. 22a neben den Rissspuren 60 auch Laserschädigungen. Die in Fig. 22b gezeigte Oberfläche ist gegensätzlich zu der in Fig. 22a gezeigten Oberfläche deutlich homogener bzw. weist weniger Schädigungen und/oder Risse auf. Der außermittig des Zentrums Z der Modifikationen erzeugte Ablösebereich 2 ermöglicht somit die Schaffung unterschiedlich strukturierter Oberflächen. Das Bezugszeichen 17 kennzeichnet eine Referenzlänge, die bevorzugt 1000 µm beträgt.

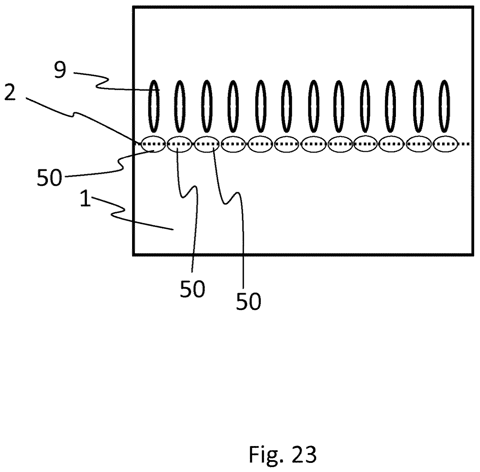

Fig. 23 zeigt schematisch, dass das Kristallgitter des Festkörpers 1 derart durch die Einbringung oder Erzeugung von Modifikationen 9 verändert wird, dass Rissführungsspannungen 50, bevorzugt beabstandet zum Zentrum Z der Modifikation/en 9, erzeugt werden. Somit werden in dem Kristallgitter durch die Modifikationen 9 in jeweils mindestens einem eine Modifikation 9 umgebenden Festkörperbereich derart Rissführungsspannungen 50 erzeugt, dass ein den Festkörper 1 trennender Riss durch die Rissführungsspannungen 50, insbesondere versetzt zum Zentrum Z der jeweiligen Modifikationen 9, geführt wird.

Die oval dargestellten Rissführungsspannungen 50 geben erfindungsgemäß einen Ablösebereich 2 vor, entlang dem und durch den ein aufgrund von mechanischen Spannungen erzeugter Riss geführt wird. Die mechanischen Spannungen werden bevorzugt über die Temperierung einer an dem Festkörper 1 angeordnet bzw. erzeugten Schicht erzeugt bzw. in den Festkörper 1 eingeleitet.

Somit kann sich die vorliegende Erfindung auf ein Verfahren zum Abtrennen von mindestens einem Festkörperanteil von einem Festkörper, insbesondere einem Wafer, beziehen. Das Verfahren umfasst dabei mindestens die Schritte: Modifizieren des Kristallgitters des Festkörpers mittels eines Lasers, insbesondere eines Piko- oder Femtosekunden-Laser, wobei mehrere Modifikationen in dem Kristallgitter erzeugt werden, wobei das Kristallgitter in Folge der Modifikationen in den die Modifikationen umgebenden Bereichen zumindest in jeweils einem Anteil einreist, wobei durch die Risse im Bereich der Modifikationen ein Ablösebereich oder mehrere Teilablösebereiche vorgegeben wird. Zusätzlich, insbesondere in Kombination, oder alternativ kann das Verfahren den Schritt des Bereitstellens eines zu bearbeitenden Festkörpers 1 umfassen, wobei der Festkörper 1 bevorzugt aus einer chemischen Verbindung besteht. Ferner kann zusätzlich oder alternativ, insbesondere als Modifikationseinrichtung eine LASER-Lichtquelle bereitgestellt werden. Ferner erfolgt bevorzugt zusätlich das Beaufschlagen des Festkörpers 1 mit LASER-Strahlung der LASER-Lichtquelle, wobei die LASER-Strahlung einen vorgegebenen Anteil des Festkörpers 1 im Inneren des Festkörpers 1 zur Ausbildung eines Ablösebereichs (2) definiert temperiert, wobei die in dem vorgegebenen Anteil des Festkörpers 1 erzeugte Temperatur so groß ist, dass das den vorgegebenen Anteil ausbildende Material eine vorbestimmte Stoffumwandlung erfährt. Die Ablösung der Festkörperschicht von dem Festkörper kann sich somit alleine aufgrund der erfindungsgemäß erzeugten Modifikationen ergeben. Bevorzugt werden die Modifikationen 9 als vorbestimmte Stoffumwandlung des den vorgegebenen Anteil ausbildenden Materials erzeugt, wobei durch die Laserstrahlen eine so hohe Temperatur, insbesondere mehr als 200°C oder mehr als 500°C oder mehr als 800°C oder mehr als 1000°C oder mehr als 1500°C oder mehr als 2000°C, erzeugt wird, dass die Stoffumwandlung bewirkt wird.

Alternativ ist jedoch vorstellbar, dass die Modifikationen derart erzeugt werden, dass sie nicht ohne einen weiteren von außen eingeleiteten Impuls eine Abtrennung der Festkörperschicht vom Festkörper ermöglichen.

Daher kann bevorzugt nach der Erzeugung der Modifikationen das Anordnen einer Aufnahmeschicht an dem Festkörper zum Halten des Festkörperanteils und danach ein thermisches Beaufschlagen der Aufnahmeschicht zum, insbesondere mechanischen, Erzeugen von Spannungen in dem Festkörper erfolgen, wobei sich durch die Spannungen ein Riss, insbesondere ein Hauptriss, in dem Festkörper entlang dem Ablösebereich ausbreitet, durch den die Festkörperschicht vom Festkörper abgetrennt wird, bevorzugt werden durch den Riss zumindest die Mehrzahl der eventuell zuvor erzeugten Teilrisse im Bereich der Modifikationen miteinander verbunden.

Somit wird ein Verfahren zum Erzeugen eines Ablösebereichs in einem Festkörper zum Ablösen eines Festkörperanteils, insbesondere einer Festkörperschicht, von dem Festkörper beschrieben, wobei der abzulösende Festkörperanteil dünner ist als der um den Festkörperanteil reduzierte Festkörper, mindestens umfassend die Schritte: Bereitstellen eines zu bearbeitenden Festkörpers, wobei der Festkörper bevorzugt aus einer chemischen Verbindung besteht; Bereitstellen einer LASER-Lichtquelle; Beaufschlagen des Festkörpers mit LASERstrahlen der LASER-Lichtquelle, wobei die Laserstrahlen über eine Oberfläche des abzutrennenden Festkörperanteils in den Festkörper eindringen, wobei die LASERstrahlen einen vorgegebenen Anteil des Festkörpers im Inneren des Festkörpers zur Ausbildung eines Ablösebereichs oder mehrerer Teilablösebereiche definiert beaufschlagt, dadurch gekennzeichnet, dass durch die Laserbeaufschlagung nacheinander mehrere Modifikationen in dem Kristallgitter des Festkörpers erzeugt werden, wobei das Kristallgitter in Folge der Modifikationen in den die Modifikationen umgebenden Bereichen zumindest in jeweils einem Anteil davon einreist, wobei durch die Risse im Bereich der Modifikationen der Ablösebereich vorgegeben wird oder mehrere Teilablösebereiche vorgegeben werden.

Ferner wird ein Verfahren zum Abtrennen von mindestens einem Festkörperanteil von einem Festkörper, insbesondere einem Wafer beschrieben, mindestens umfassend die Schritte: Modifizieren des Kristallgitters des Festkörpers mittels eines Modifikationsmittels, insbesondere eines Lasers, insbesondere eines Piko- oder Femtosekunden-Laser, wobei mehrere Modifikationen in dem Kristallgitter erzeugt werden, wobei das Kristallgitter in Folge der Modifikationen in den die Modifikationen umgebenden Bereichen zumindest in jeweils einem Anteil davon einreist, wobei durch die Risse im Bereich der Modifikationen ein Ablösebereich vorgegeben wird, Anordnen einer Aufnahmeschicht an dem Festkörper zum Halten des Festkörperanteils, thermisches Beaufschlagen der Aufnahmeschicht zum, insbesondere mechanischen, Erzeugen von Spannungen in dem Festkörper, wobei sich durch die Spannungen ein Hauptriss in dem Festkörper entlang dem Ablösebereich ausbreitet, der zumindest die Mehrzahl der Risse im Bereich der Modifikationen miteinander verbindet.

**Bezugszeichenliste**

| | | | |
|---|---|---|---|
| 1 | Festkörper Modifikationsblock oderAußenkante | | |
| 2 | Ablösebereich | | |
| 4 | Laserstrahl | 34 | Riss zwischen Modifikationsblock und Außenkante |
| 5 | Polierte Oberfläche | 40 | Optik |
| 6 | Laserstrahl im Festkörper | 41 | erste Bereich ohne Modifikationsblock |
| 7 | Unterseite des Festkörpers | | |
| 8 | Fokus | 42 | zweiter Bereich ohne Modifikationsblock |
| 9 | Modifikation | | |
| 10 | Erster Festkörperteil | 43 | dritter Bereich ohne Modifikationsblock |
| 11 | Festkörperschicht | | |
| 12 | Zweiter Festkörperteil | 44 | vierter Bereich ohne Modifikationsblock |
| 13 | Riss | 45 | fünfter Bereich ohne Modifikationsblock |
| 14 | Ort des Bearbeitungsstarts | | |
| 15 | Zentrum der Modifikationen | 51 | unveränderter Stoff |
| 17 | Referenzlänge | 52 | veränderter Stoff |
| 18 | Hauptoberfläche | 53 | Ramanspektrum |
| 25 | erster Rissanteil | 54 | Intensität in % |
| 27 | zweiter Rissanteil | 56 | Wellenlänge in cm⁻¹ |
| 28 | dritter Rissanteil | 61 | Graph zum unveränderten Stoffanteil |
| 29 | vierter Rissanteil | | |
| 30 | Rotationstisch | 62 | Graph zu verändertem Stoffanteil |
| 31 | Riss zwischen Außenkante und erstem Modifikationsblock | | |
| | | 65 | erstes Ausrichtelement |
| 32 | Riss zwischen zwei Modifikationsblöcken | 66 | zweites Ausrichtelement |
| | | 67 | drittes Ausrichtelement |
| 33 | Riss zwischen Modifikationsblock und weiterem | 68 | viertes Ausrichtelement |
| 69 | Sensormittel | 403 | weiterer Laserstrahlenleiter |
| 75 | Datenträgerelemen tund/oder Datenübertragungselement | 501 | Freigelegte Oberfläche der ersten Festkörperschicht |
| | | 502 | Lasereindringoberfläche der zweiten Festkörperschicht |
| 76 | Nut | | |
| 77 | Fluideingang | 503 | Freigelegte Oberfläche der zweiten Festkörperschicht |
| 78 | Fluidleitung | | |
| 79 | Fluidausgang | 504 | Lasereindringoberfläche der dritten Festkörperschicht |
| 80 | Leit-Stütz-Struktur | 505 | Freigelegte Oberfläche der dritten Festkörperschicht |
| 71 | erstes Ende eines Rissanteils | | |
| | | 606 | Lichtstrahl |
| 72 | zweites Ende eines Rissanteils | 608 | Optik |
| 91 | erster Block an Modifikationen | 610 | erstes Umlenkelement |
| | | 612 | zweites Umlenkelement |
| 92 | zweiter Block an Modifikationen | 613 | drittes Umlenkelement |
| | | 616 | erster Lichtstrahlanteil |
| 112 | zweite Festkörperschicht | 618 | zweiter Lichtstrahlanteil |
| 113 | dritte Festkörperschicht | 620 | Fokus |
| 140 | Aufnahmeschicht | 622 | erster Oberflächenanteil |
| 150 | Temperierungsfluid | 624 | zweiter Oberflächenanteil |
| 161 | Verformungsrichtung der Aufnahmeschicht | 630 | Lichtstrahltaille |
| | | 632 | Lichtstrahltaille |
| 300 | Kopplungsschicht | 901 | erstes Feld ohne Modifikationen |
| 630 | Lichtstrahltaille | | |
| 632 | Lichtstrahltaille | 902 | zweites Feld ohne Modifikationen |
| 400 | Scanner | | |
| 401 | Laserstrahlenquelle | 903 | drittes Feld ohne Modifikationen |
| 402 | Laserstrahlenleiter | | |

## Patentansprüche

1. Verfahren zum Erzeugen eines Ablösebereichs (2) in einem Festkörper (1), wobei der Festkörper (1) Siliziumcarbid aufweist oder daraus besteht, umfassend:
Erzeugen von Modifikationen (9) im Inneren des Festkörpers (1) mit mindestens einem Laserstrahl,
wobei der Laserstrahl ein Piko- oder Femtosekunden-Laserstrahl ist,
wobei der Laserstrahl über eine Hauptoberfläche (5, 18) des Festkörpers (1) in den Festkörper (1) eindringt,
wobei in Folge der Modifikationen (9) in die Modifikationen (9) umgebenden Bereichen ein Kristallgitter des Festkörpers (1) zumindest in jeweils einem Anteil unterkritisch einreißt,
wobei sich unterkritische Risse jeweils parallel oder im Wesentlichen parallel zu der Hauptoberfläche (5, 18) ausbreiten,
wobei durch die unterkritischen Risse im Bereich der Modifikationen (9) der Ablösebereich (2) vorgegeben wird; und
wobei sich die unterkritischen Risse entlang dem Ablösebereich (2) zu einem Hauptriss verbinden,
wobei der Hauptriss einen Festkörperanteil (10, 12) von dem Festkörper (1) abtrennt.

2. Verfahren nach Anspruch 1,
wobei eine Energie des Laserstrahls derart gewählt wird, dass eine Ausdehnung jeder der Modifikationen (9) im Festkörper (1) kleiner als dreimal die Rayleighlänge ist.

3. Verfahren nach Anspruch 1,
wobei eine Energie des Laserstrahls derart gewählt wird, dass eine Ausdehnung jeder der Modifikationen (9) im Festkörper (1) in zumindest einer Richtung kleiner als dreimal die Rayleighlänge ist.

4. Verfahren nach einem der vorangehenden Ansprüche,
wobei der Festkörper (1) ein für den Laserstrahl zumindest teilweise transparentes Material aufweist oder daraus besteht.

5. Verfahren nach einem der vorangehenden Ansprüche,
wobei bei dem Erzeugen von Modifikationen (9) im Inneren des Festkörpers (1) mit dem mindestens einen Laserstrahl die Ausbreitung der unterkritischen Risse stoppt, bevor der Festkörperanteil (10, 12) von dem Festkörper (1) abgetrennt wird.

6. Verfahren nach einem der vorangehenden Ansprüche,
wobei bei dem Erzeugen von Modifikationen (9) im Inneren des Festkörpers (1) mit dem mindestens einen Laserstrahl ein die Modifikationen (9) ausbildender Anteil des Festkörpers (1) durch Bestrahlung mit dem Laserstrahl eine Stoffumwandlung und/oder Phasenumwandlung erfährt.

7. Verfahren nach Anspruch 6,
wobei aus der Stoffumwandlung und/oder der Phasenumwandlung neue Stoffe oder Phasen hervorgehen, insbesondere kristalline und/oder amorphe Phasen, insbesondere Si(Silizium)-Phasen und DLC(diamond-like carbon)-Phasen.

8. Verfahren zum Abtrennen eines Festkörperanteils (10, 12) von einem Festkörper (1), umfassend
Erzeugen eines Ablösebereichs (2) in dem Festkörper (1) nach dem Verfahren gemäß einem der vorangehenden Ansprüche; und
Abtrennen des Festkörperanteils (10, 12) von dem Festkörper (1) entlang dem Ablösebereich.

9. Verfahren nach dem vorangehenden Anspruch,
wobei sich beim Abtrennen die unterkritischen Risse entlang des Ablösebereiches (2) zu einem Hauptriss verbinden.

10. Verfahren nach Anspruch 9,
wobei die Modifikationen (9) so erzeugt werden, dass sich die Abtrennung des Festkörperanteils (10, 12) vom Festkörper (1) allein aufgrund der Modifikationen (9) ergibt.

11. Verfahren nach Anspruch 9,
wobei die die Modifikationen (9) so erzeugt werden, dass die Ausbildung des die einzelnen Risse verbindenden Hauptrisses durch lokal unterschiedliche Modifikationskonzentrationen oder Modifikationsverteilungen ausgelöst wird.

12. Verfahren nach Anspruch 9,
wobei die Modifikationen (9) so erzeugt werden, dass die Abtrennung des Festkörperanteils (10, 12) vom Festkörper (1) entlang dem Ablösebereich (2) ohne einen weiteren von außen eingeleiteten Impuls nicht möglich ist.

13. Verfahren nach Anspruch 9,
wobei sich der Hauptriss durch Einleiten mechanischer Spannungen entlang des Ablösebereichs (2) ausbreitet.

14. Verfahren nach einem der zwei vorangehenden Ansprüche,
wobei der vom Festkörper (1) abgetrennte Festkörperanteil (10, 12) dünner ist als der um den Festkörperanteil (10, 12) reduzierte Festkörper (1).

15. Verfahren nach einem der zwei vorangehenden Ansprüche,
wobei die Hauptoberfläche (5, 18) eine Oberfläche des vom Festkörper (1) abzutrennenden Festkörperanteils (10, 12) ist

## Claims

1. Method of creating a detachment region (2) in a solid-state body (1), wherein the solid-state body (1) includes or consists of silicon carbide, comprising:
creating modifications (9) within the solid-state body (1) with at least one laser beam,
wherein the laser beam is a pico- or femtosecond laser beam,
wherein the laser beam penetrates into the solid-state body (1) via a main surface (5, 18) of the solid-state body (1),
wherein, as a result of the modifications (9), a crystal lattice of the solid-state body (1) undergoes subcritical tearing at least in a fraction of each of the regions surrounding the modifications (9),
wherein subcritical cracks are each propagated parallel or essentially parallel to the main surface (5, 18),
wherein the subcritical cracks in the region of the modifications (9) define the detachment region (2); and
wherein the subcritical cracks join along the detachment region (2) to form a main crack,
wherein the main crack separates a fraction (10, 12) of the solid-state body from the solid-state body (1).

2. Method according to Claim 1,
wherein an energy of the laser beam is chosen such that an expansion of each of the modifications (9) in the solid-state body (1) is less than three times the Rayleigh length.

3. Method according to Claim 1,
wherein an energy of the laser beam is chosen such that an expansion of each of the modifications (9) in the solid-state body (1) in at least one direction is less than three times the Rayleigh length.

4. Method according to any of the preceding claims, wherein the solid-state body (1) includes or consists of a material that is at least partially transparent to the laser beam.

5. Method according to any of the preceding claims, wherein, in the creating of modifications (9) within the solid-state body (1) with the at least one laser beam, the propagation of the subcritical cracks stops before the fraction (10, 12) of the solid-state body is separated from the solid-state body (1).

6. Method according to any of the preceding claims, wherein, in the creating of modifications (9) within the solid-state body (1) with the at least one laser beam, a fraction of the solid-state body (1) that forms the modifications (9) undergoes a transformation of matter and/or phase transformation via irradiation with the laser beam.

7. Method according to Claim 6,
wherein the transformation of matter and/or the phase transformation results in new substances or phases, in particular crystalline and/or amorphous phases, in particular Si (silicon) phases and DLC (diamond-like carbon) phases.

8. Method of separating a fraction (10, 12) of a solid-state body from a solid-state body (1), comprising creating a detachment region (2) in the solid-state body (1) by the method according to any of the preceding claims; and
separating the fraction (10, 12) of the solid-state body from the solid-state body (1) along the detachment region.

9. Method according to the preceding claim,
wherein, in the separating operation, the subcritical cracks join along the detachment region (2) to form a main crack.

10. Method according to Claim 9,
wherein the modifications (9) are created in such a way that the separation of the fraction (10, 12) of the solid-state body from the solid-state body (1) arises solely on account of the modifications (9).

11. Method according to Claim 9,
wherein the modifications (9) are created in such a way that the formation of the main crack connecting the individual cracks is triggered by locally different modification concentrations or modification distributions.

12. Method according to Claim 9,
wherein the modifications (9) are created in such a way that the separation of the fraction (10, 12) of the solid-state body from the solid-state body (1) along the detachment region (2) is not possible without a further externally initiated stimulus.

13. Method according to Claim 9,
wherein the main crack is propagated along the detachment region (2) by introduction of mechanical stresses.

14. Method according to either of the two preceding claims,
wherein the fraction (10, 12) of the solid-state body separated from the solid-state body (1) is thinner than the solid-state body (1) reduced by the fraction (10, 12) of the solid-state body.

15. Method according to either of the two preceding claims,
wherein the main surface (5, 18) is a surface of the fraction (10, 12) of the solid-state body to be separated from the solid-state body (1).

## Revendications

1. Procédé de production d'une partie (2) de détachement dans un corps (1) solide, dans lequel le corps (1) solide a du carbure de silicium ou en est constitué, comprenant :
production de modifications (9) à l'intérieur du corps (1) solide par au moins un faisceau laser,
dans lequel le faisceau laser est un faisceau laser à picosecondes ou à femtosecondes,
dans lequel le faisceau laser pénètre dans le corps (1) solide en passant par une surface (5, 18) principale du corps (1) solide,
dans lequel, en raison des modifications (9) dans les parties entourant les modifications (9), un réseau cristallin du corps (1) solide se détruit de manière sous-critique au moins pour une certaine part,
dans lequel des fissures sous-critiques se propagent respectivement parallèlement ou sensiblement parallèlement à la surface (5, 18) principale,
dans lequel, par les fissures sous-critiques dans la partie des modifications (9), on prescrit la région (2) de détachement ; et
dans lequel les fissures sous-critiques se relient le long de la partie (2) de détachement en une fissure principale,
dans lequel la fissure principale sépare du corps (1) solide une part (10, 12) du corps solide.

2. Procédé suivant la revendication 1,
dans lequel on choisit une énergie du faisceau laser, de manière à ce qu'une étendue de chacune des modifications (9) dans le corps (1) solide soit plus petite que trois fois la longueur de Rayleigh.

3. Procédé suivant la revendication 1,
dans lequel on choisit une énergie du faisceau de laser, de manière à ce qu'une étendue de chacune des modifications (9) dans le corps (1) solide soit au moins dans une direction plus petite que trois fois la longueur de Rayleigh.

4. Procédé suivant l'une des revendications précédentes,
dans lequel le corps (1) solide a un matériau transparent au moins en partie au faisceau laser ou en est constitué.

5. Procédé suivant l'une des revendications précédentes,
dans lequel, lors de la production de modifications (9) à l'intérieur du corps (1) solide par le au moins un faisceau laser, on arrête la propagation des fissures sous-critiques, avant de séparer du corps (1) solide la part (10, 12) du corps solide.

6. Procédé suivant l'une des revendications précédentes,
dans lequel, lors de modifications (9) à l'intérieur du corps (1) solide par le au moins un faisceau laser, une part, constituant les modifications (9), du corps (1) solide subit, par l'exposition au faisceau laser, une transformation de matière et/ou une transformation de phase.

7. Procédé suivant la revendication 6,
dans lequel, à partir de la transformation de matière et/ou de la transformation de phase, naissent de nouvelles matières ou phases, en particulier des phases cristallines et/ou amorphes, en particulier des phases de Si (silicium) ou des phases de DLC (carbone semblable au diamant).

8. Procédé de séparation d'une part (10, 12) de corps solide d'un corps (1) solide, comprenant
production d'une partie (2) de détachement dans le corps (1) solide par le procédé suivant l'une des revendications précédentes, et
séparation du corps (1) solide de la part (10, 12) de corps solide le long de la partie de détachement.

9. Procédé suivant la revendication précédente,
dans lequel, lors de la séparation, les fissures sous-critiques le long de la partie (2) de détachement se relient en une fissure principale.

10. Procédé suivant la revendication 9,
dans lequel on produit les modifications (9), de manière à ce que la séparation de la part (10, 12) du corps solide du corps (1) solide se produise seulement en raison des modifications (9).

11. Procédé suivant la revendication 9,
dans lequel on produit les modifications (9), de manière à ce que la constitution de la fissure principale reliant les diverses fissures soit déclenchée par des concentrations de modifications ou des répartitions de modifications différentes localement.

12. Procédé suivant la revendication 9,
dans lequel on produit les modifications (9), de manière à ce que la séparation de la part (10, 12) de corps solide du corps (1) solide le long de la partie (2) de détachement ne soit pas possible sans une autre force impulsive appliquée de l'extérieur.

13. Procédé suivant la revendication 9,
dans lequel la fissure principale se propage par application de contraintes mécaniques le long de la partie (2) de détachement.

14. Procédé suivant l'une des deux revendications précédentes,
dans lequel la part (10, 12) de corps solide séparée du corps (1) solide est plus mince que le corps (1) solide réduit de la part (10, 12) du corps solide.

15. Procédé suivant l'une des deux revendications précédentes,
dans lequel la surface (5, 18) principale est une surface de la part (10, 12) du corps solide à séparer du corps (1) solide.
